(19) Europäisches Patentamt
European Patent Office
Office européen des brevets

(11) **EP 4 750 010 A1**

(12) **EUROPEAN PATENT APPLICATION**
published in accordance with Art. 153(4) EPC

(43) Date of publication:
**27.05.2026 Bulletin 2026/22**

(21) Application number: **24861813.4**

(22) Date of filing: **19.08.2024**

(51) International Patent Classification (IPC):
***H04L 27/26*** (2006.01)

(52) Cooperative Patent Classification (CPC):
**G06F 17/14; H03M 1/08; H03M 1/12; H04L 27/26**

(86) International application number:
**PCT/CN2024/113195**

(87) International publication number:
**WO 2025/050969 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **08.09.2023 CN 202311160179**

(71) Applicant: **Huawei Technologies Co., Ltd.
Shenzhen, Guangdong 518129 (CN)**

(72) Inventors:
• **HE, Hongli
Shenzhen, Guangdong 518129 (CN)**
• **LI, Xueru
Shenzhen, Guangdong 518129 (CN)**

(74) Representative: **Pfenning, Meinig & Partner mbB
Patent- und Rechtsanwälte
Theresienhöhe 11a
80339 München (DE)**

(54) **SIGNAL RECEPTION METHOD AND APPARATUS**

(57) A signal receiving method and an apparatus are provided, to reduce a peak power of a signal input to an analog-to-digital converter ADC, so as to reduce quantization noise and improve signal receiving performance. The method includes: A receiving device receives a first signal, performs down-conversion on the first signal to obtain a second signal, then determines a third signal based on the second signal, and samples the third signal to determine a target signal. The first signal includes the target signal, and comb mapping is used for the target signal, to be specific, the target signal occupies one subcarrier in every $M$ consecutive subcarriers. The third signal includes superposition of $K$ delayed signals of the second signal, and delay time associated with a $k^{th}$ delayed signal in the $K$ delayed signals is formula (1). $T$ is a time length of the first signal, $k = 1, 2, ... , or K$, $\delta$ is greater than or equal to 0, $M$ is a positive integer greater than 1, and $K$ is a positive integer greater than or equal to $M$.

S401: A receiving device receives a first signal, where the first signal includes a target signal, and the target signal occupies one subcarrier in every $M$ consecutive subcarriers

S402: The receiving device performs down-conversion on the first signal to obtain a second signal

S403: The receiving device determines a third signal based on the second signal, where the third signal includes superposition of K delayed signals of the second signal, and delay time associated with a $k^{th}$ delayed signal is $\frac{(k-1)T}{K} + \delta$

S404: The receiving device samples the third signal

S405: The receiving device determines the target signal

FIG. 4

**Description**

This application claims priority to Chinese Patent Application No. 202311160179.2, filed with the China National Intellectual Property Administration on September 8, 2023 and entitled "SIGNAL RECEIVING METHOD AND APPARATUS", which is incorporated herein by reference in its entirety.

**TECHNICAL FIELD**

Embodiments of this application relate to the communication field, and in particular, to a signal receiving method and an apparatus.

**BACKGROUND**

In the future, wireless sensing may be an important part of a mobile communication system. To implement harmonious coexistence of communication and sensing and sharing of radio frequency and baseband devices in communication and sensing, an orthogonal frequency division multiplexing (orthogonal frequency domain multiplexing, OFDM) waveform may be used in the mobile communication system to implement communication and sensing.

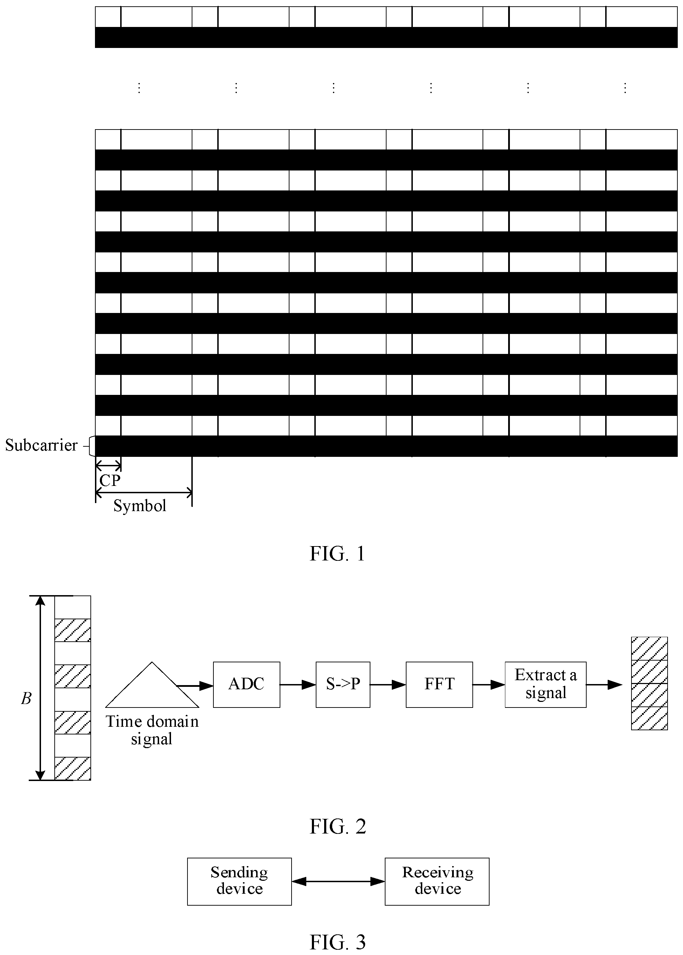

In a wireless sensing scenario based on the OFDM waveform, a sensing device may send a signal in a comb (comb) manner or an interlace (interlace) manner. For example, as shown in FIG. 1, one subcarrier in every M (for example, M=2) consecutive subcarriers may be used by the sensing device to send a sensing signal, and the other subcarriers in the M consecutive subcarriers may be used by another sensing device or communication device to send a signal.

In a signal receiving process based on the OFDM waveform, a receiver inputs a time domain signal on an entire bandwidth to an analog-to-digital converter (analog-to-digital converter, ADC), to convert a time domain analog signal into a time domain digital signal; then, a frequency domain digital signal is obtained through serial-to-parallel (sequence to parallel, S->P) conversion and fast Fourier transform (fast Fourier transform, FFT); and finally, a signal on a subcarrier on which the sensing signal is located is extracted from the frequency domain digital signal for subsequent processing.

Due to limited quantization precision of the ADC, additional quantization noise is usually generated after a signal passes through the ADC. In the foregoing signal receiving process, the quantization noise of the ADC depends on a sum of powers of the sensing signal and a signal of another user. If the power of the signal of the another user received by the receiver is excessively high, large quantization noise is caused, affecting receiving performance.

**SUMMARY**

Embodiments of this application provide a signal receiving method and an apparatus, to reduce a peak power of a signal input to an ADC, so as to reduce quantization noise and improve signal receiving performance.

According to a first aspect, a signal receiving method is provided. The method may be performed by a receiving device, may be performed by a component of the receiving device, for example, a processor, a chip, or a chip system of the receiving device, or may be implemented by a logical module or software that can implement all or some functions of the receiving device. The method includes: receiving a first signal, where the first signal includes a target signal, the target signal occupies one subcarrier in every $M$ consecutive subcarriers, and $M$ is a positive integer greater than 1; performing down-conversion on the first signal to obtain a second signal; determining a third signal based on the second signal, where the third signal includes superposition of $K$ delayed signals of the second signal, and delay time associated with a $k^{th}$ delayed signal in the $K$ delayed signals is $\dfrac{(k-1)T}{K} + \delta$, where $T$ is a time length of the first signal, $k = 1, 2,..., or K$, $\delta$ is greater than or equal to 0, and $K$ is a positive integer greater than or equal to M; and sampling the third signal to determine the target signal.

Based on this solution, because the delay time associated with the $k^{th}$ delayed signal is $\dfrac{(k-1)T}{K} + \delta$, the $K$ delayed signals of the second signal may be equivalent to periodic extension of the second signal. Performing sampling in frequency domain is equivalent to performing periodic extension on a signal in time domain, and extracting the target signal from an entire bandwidth may be understood as sampling in frequency domain. Therefore, after periodic extension and superposition are performed in time domain, it may be considered that the target signal has been extracted. In this case, a signal input to an ADC during sampling does not include a signal of another user. In other words, a peak power of the signal input to the ADC is a power of the target signal, and does not include a power of the signal of the another user. In this way, the peak power of the signal input to the ADC can be reduced, so as to reduce quantization noise and improve signal receiving performance.

In a possible design, the time length of the first signal is a length of one OFDM symbol. In other words, the first signal may be understood as a signal on one OFDM symbol. The length of one OFDM symbol may be a length of a part excluding a CP part.

In a possible design, a frequency of the down-conversion is related to a carrier frequency of the first signal and/or a position of the target signal. For example, the frequency of the down-conversion may be the same as a frequency of a subcarrier included (or occupied) by the target signal.

Based on the possible design, after the down-conversion, a radio frequency signal (that is, the first signal) having a high frequency may be shifted to a baseband for processing. In addition, the frequency of the down-conversion is determined based on the carrier frequency of the first signal and/or the position of the target signal, and the target signal may be aligned with a baseband zero frequency after the down-conversion, to facilitate subsequent processing.

In a possible design, determining the third signal based on the second signal includes: delaying the second signal $K$ times to obtain the $K$ delayed signals of the second signal, where the delay time associated with the $k^{th}$ delayed signal is $\frac{(k-1)T}{K} + \delta$; and superposing the $K$ delayed signals to obtain the third signal. Based on the possible design, the third signal may be obtained by directly delaying the second signal $K$ times and superposing the delayed signals.

In a possible design, determining the third signal based on the second signal includes: determining the third signal by using an $X$-stage circuit, where in the $X$-stage circuit, an output signal of an $i^{th}$-stage circuit is a signal obtained by superposing an input signal of the $i^{th}$-stage circuit and a signal obtained by delaying the input signal of the $i^{th}$-stage circuit, where i = 1, 2,..., or $X$, and $X$ is a positive integer greater than 1. When $i = 1$, the input signal of the $i^{th}$-stage circuit is a signal obtained by delaying the second signal by $\delta$, or when $i > 1$, the input signal of the $i^{th}$-stage circuit is an output signal of an $(i-1)^{th}$-stage circuit, the third signal is an output signal of an $X^{th}$-stage circuit, and the output signal of the $X^{th}$-stage circuit includes superposition of the $K$ delayed signals of the second signal.

In a possible design, $K = 2^X$, and the output signal of the $i^{th}$-stage circuit is a signal obtained by superposing the input signal of the $i^{th}$-stage circuit and a signal obtained by delaying the input signal of the $i^{th}$-stage circuit by $\frac{T}{2^i}$.

Based on the possible design, because the input signal of the $i^{th}$-stage circuit needs to be delayed only once, only one delayer is needed in each stage of circuit. In other words, only a total of $X$ delayers are needed to determine the third signal. This can reduce a quantity of delayers, to reduce costs of the receiving device.

In a possible design, $K = \prod_{i=1}^{X} K_i$, and the output signal of the $i^{th}$-stage circuit is a signal obtained by superposing the input signal of the $i^{th}$-stage circuit and signals obtained by respectively delaying the input signal of the $i^{th}$-stage circuit by $\frac{T}{\prod_{j=1}^{i} K_j}, \frac{2T}{\prod_{j=1}^{i} K_j}, ..., $ and $\frac{(K_i-1)T}{\prod_{j=1}^{i} K_j}$, where $\Pi$ represents cumulative multiplication, and $K_i$ is a positive integer.

In a possible design, $K = M$, and sampling the third signal includes: sampling the third signal within a time range of $\left[\frac{M-1}{M}T + \delta, T + \delta\right]$, where a reference point of the time range is start time of the first signal.

Based on the possible design, a length of a time domain range may be $\frac{T}{M}$. In other words, within a time length $T$ of one OFDM symbol, duration in which an ADC used for sampling is turned on or operating is only required to be $\frac{T}{M}$. In comparison with a case in which the ADC is always turned on within the time length T, this case can reduce sampling power consumption of the ADC, to reduce power consumption of the receiving device. In addition, based on the possible design, if a sampling rate for sampling the third signal within the time range is $N\Delta f_C$, when the length of the time domain range is $\frac{T}{M}$, the target signal includes $\frac{N}{M}$ sampling points in time domain. Subsequently, only $\frac{N}{M}$-point discrete Fourier transform (discrete Fourier transform, DFT) needs to be performed to obtain a frequency domain signal corresponding to the target signal. In comparison with a solution in which at least $N$-point DFT is performed on a signal on an entire OFDM symbol, this solution can reduce a quantity of DFT points, and reduce a capability requirement and costs for a DFT module.

In a possible design, $K = M$, and sampling the third signal includes: delaying the third signal $A$ times to obtain $A$ delayed signals of the third signal, where $A$ is a positive integer, delay time associated with an $a^{th}$ delayed signal is $\frac{(a-1)T}{M} + \delta_a$, $\delta_a$ is greater than or equal to 0, and a = 1, 2,..., or $A$; and sampling the $a^{th}$ delayed signal of the third signal within a time range of $\left[\frac{M+a-2}{M}T + \delta + \sum_{j=1}^{a} \delta_j, \frac{M+a-1}{M}T + \delta + \sum_{j=1}^{a} \delta_j\right]$, where a reference point of the time range is start time of the first signal. For example, A is a positive integer less than or equal to *M*. In a special case, *A* = *M*.

In a possible design, a sampling frequency used for sampling the *a*th delayed signal of the third signal is greater than or equal to *N*Δ*f_C*/A, where *N* is greater than or equal to a quantity of subcarriers included in a bandwidth of the first signal, *N* is a positive integer, and Δ*f_C* is a bandwidth of the subcarrier. Alternatively, a sampling frequency of the *a*th delayed signal of the third signal is *B*/*A*, and *B* is a bandwidth of the first signal.

Based on the possible design, the receiving device delays the third signal *A* times, and samples the delayed signal of the third signal within the foregoing time domain range. This is equivalent to making an additional copy of a signal of the target signal in time domain, and sampling a plurality of copied time domain signals. It may be considered that a time length of total sampling samples is increased. When a total quantity of sampling points remains unchanged, each sampling sample may be sampled by using a low sampling frequency, so that the sampling frequency can be reduced, and a performance requirement and costs for an ADC are also reduced.

In a possible design, sampling positions of any two delayed signals in the A delayed signals of the third signal are different.

Based on the possible design, the different sampling positions of the any two delayed signals can ensure that sampling points of the any two delayed signals are different, and corresponding sampling results are not repeated, to ensure sufficient sampling and improve sampling performance.

In a possible design, *K* = *M* - 1 + *C*, and *C* is a positive integer. For example, *C* is a positive integer less than or equal to *M*. In a special case, *C* = *M*.

In a possible design, sampling the third signal includes: performing *C* segments of sampling on the third signal. A *c*th segment of sampling corresponds to a signal of the third signal within a time range *c*, *c* = 1, 2, ... , or *C*, and the time range *c* is

$$\left[\frac{M+c-2}{M}T + \delta, \frac{M+c-1}{M}T + \delta\right].$$

A reference point of the time range c is start time of the first signal.

In a possible design, a sampling frequency used for performing C segments of sampling on the third signal is greater than or equal to *N*Δ*f_C*/C, where *N* is greater than or equal to a quantity of subcarriers included in a bandwidth of the first signal, *N* is a positive integer, and Δ*f_C* is a bandwidth of the subcarrier.

Based on the foregoing two possible designs, the sampling frequency and a quantity of DFT points can also be reduced, so that capability requirements and costs for an ADC and a DFT module are reduced.

In a possible design, sampling positions in any two segments of sampling in the C segments of sampling of the third signal are different.

In a possible design, sampling the third signal to determine the target signal includes: sampling the third signal to obtain a first time domain sequence, and performing *N*/*M*-point discrete Fourier transform DFT on the first time domain sequence to obtain a frequency domain signal corresponding to the target signal, where *N* is greater than or equal to the quantity of subcarriers included in the bandwidth of the first signal, and *N* is a positive integer.

Based on the possible design, only $\frac{N}{M}$ -point DFT needs to be performed to obtain the frequency domain signal corresponding to the target signal. In comparison with a solution in which at least *N*-point DFT is performed on a signal on an entire OFDM symbol, this solution can reduce a quantity of DFT points, and reduce a capability requirement and costs for a DFT module.

According to a second aspect, an apparatus is provided. The apparatus may be a communication apparatus or a sensing apparatus. The apparatus includes a first circuit. The first circuit is configured to determine a third signal based on a second signal, where the third signal includes superposition of *K* delayed signals of the second signal, and delay time associated with a *k*th delayed signal in the *K* delayed signals is $\frac{(k-1)T}{K} + \delta$ ; the second signal is a signal obtained by performing down-conversion on a first signal, the first signal includes a target signal, the target signal occupies one subcarrier in every M consecutive subcarriers, *M* is a positive integer greater than 1, *T* is a time length of the first signal, *k* = 1, 2, ..., or *K*, *δ* is greater than or equal to 0, and *K* is a positive integer greater than or equal to *M*; and the third signal is an input signal of an analog-to-digital converter. For technical effect brought by the second aspect, refer to the technical effect brought by the first aspect. Details are not described herein again.

In a possible design, the apparatus further includes at least one of the following: an antenna, a frequency mixer, the analog-to-digital converter, a DFT module, and a second circuit.

In a possible design, the first circuit includes *K* delayers and one adder. A *k*th delayer in the *K* delayers is configured to delay the second signal by $\frac{(k-1)T}{K} + \delta$ to obtain the *k*th delayed signal of the second signal. The adder is configured to superpose the $K$ delayed signals of the second signal to obtain the third signal. The adder is a $K$-input adder.

In a possible design, in a special case, when $\delta = 0$, a delay associated with a 1st delayed signal in the foregoing design is 0. In this case, the 1st delayed signal is equivalent to the second signal. Therefore, the 1st delayed signal can be obtained without using the delayer. Therefore, the first circuit may include $K$ - 1 delayers and one adder. A $k$th delayer in the $K$ - 1 delayers is configured to delay the second signal by $\dfrac{kT}{K}$ to obtain the $k$th delayed signal of the second signal. The adder is configured to superpose the second signal and $K$ - 1 delayed signals of the second signal to obtain the third signal. The adder is a $K$-input adder. Based on the possible design, one delayer may be reduced.

In a possible design, the first circuit includes an $X$-stage circuit, and in the $X$-stage circuit, an output signal of an $i$th-stage circuit is a signal obtained by superposing an input signal of the $i$th-stage circuit and a signal obtained by delaying the input signal of the $i$th-stage circuit, where $i = 1, 2, ...$, or $X$, and $X$ is a positive integer greater than 1. When $i = 1$, the input signal of the $i$th-stage circuit is a signal obtained by delaying the second signal by $\delta$, or when $i > 1$, the input signal of the $i$th-stage circuit is an output signal of an $(i - 1)$th-stage circuit, the third signal is an output signal of an $X$th-stage circuit, and the output signal of the $X$th-stage circuit includes superposition of the $K$ delayed signals of the second signal.

In a possible design, when $K = 2^X$, the $i$th-stage circuit includes one delayer and one adder. The delayer is configured to delay the input signal of the $i$th-stage circuit by $\dfrac{T}{2^i}$. The adder is configured to superpose the input signal of the $i$th-stage circuit and an output signal of the delayer in the $i$th-stage circuit.

In a possible design, when $K = \prod_{i=1}^{X} K_i$, the $i$th-stage circuit includes $K_i$ - 1 delayers and one adder. The $K_i$ - 1 delayers are respectively configured to delay the input signal of the $i$th-stage circuit by $\dfrac{T}{\prod_{j=1}^{i} K_j}$, $\dfrac{2T}{\prod_{j=1}^{i} K_j}$, ..., and $\dfrac{(K_i-1)T}{\prod_{j=1}^{i} K_j}$. The adder is configured to superpose the input signal of the $i$th-stage circuit and output signals of the $K_i$ - 1 delayers in the $i$th-stage circuit.

In a possible design, when $K = M$, the analog-to-digital converter is configured to sample the third signal within a time range of $\left[\dfrac{M-1}{M}T + \delta, T + \delta\right]$, where a reference point of the time range is start time of the first signal.

In a possible design, when $K = M$, the second circuit is configured to delay the third signal $A$ times to obtain $A$ delayed signals of the third signal, where $A$ is a positive integer, delay time associated with an $a$th delayed signal is $\dfrac{(a-1)T}{M} + \delta_a$, $\delta_a$ is greater than or equal to 0, and $a = 1, 2, ...,$ or $A$. The analog-to-digital converter is configured to sample the $a$th delayed signal of the third signal within a time range of $\left[\dfrac{M+a-2}{M}T + \delta + \sum_{j=1}^{a} \delta_j, \dfrac{M+a-1}{M}T + \delta + \sum_{j=1}^{a} \delta_j\right]$, where a reference point of the time range is start time of the first signal.

In a possible design, when $K = M$ - 1 + $B$, and $B$ is a positive integer, the analog-to-digital converter is configured to perform C segments of sampling on the third signal. A $c$th segment of sampling corresponds to a signal of the third signal within a time range $c$, $c = 1, 2, ...$, or $C$, and the time range $c$ is

$$\left[\dfrac{M+c-2}{M}T + \delta, \dfrac{M+c-1}{M}T + \delta\right].$$

A reference point of the time range c is start time of the first signal.

In a possible design, the DFT module is configured to perform $N/M$-point discrete Fourier transform DFT on a first time domain sequence to obtain a frequency domain signal corresponding to the target signal, where the first time domain sequence is a sampling result corresponding to the third signal, $N$ is greater than or equal to a quantity of subcarriers included in a bandwidth of the first signal, and $N$ is a positive integer.

In a possible design, the antenna is configured to receive the first signal. The first signal includes the target signal, and the target signal occupies one subcarrier in every $M$ consecutive subcarriers.

In a possible design, the frequency mixer is configured to perform down-conversion on the first signal to obtain the second signal.

In a possible design, the apparatus according to the second aspect is a chip or a chip system.

For technical effects brought by any possible design of the second aspect, refer to the technical effects brought by the corresponding design of the first aspect. Details are not described herein again.

According to a third aspect, an apparatus is provided. The apparatus may be a communication apparatus or a sensing apparatus. The apparatus includes a unit or a module, and the unit or the module is configured to perform any method according to the first aspect. The module or the unit may be implemented by hardware or software, or implemented by hardware executing corresponding software. The hardware or the software includes one or more modules or units corresponding to functions.

In some possible designs, the apparatus may include a processing module and a transceiver module. The processing module may be configured to implement a processing function in any one of the foregoing aspects and the possible implementations of the foregoing aspects. The transceiver module may include a receiving module and a sending module that are respectively configured to implement a receiving function and a sending function in any one of the foregoing aspects and the possible implementations of the foregoing aspects.

In some possible designs, the transceiver module may include a transceiver circuit, a transceiver machine, a transceiver, or a communication interface.

According to a fourth aspect, an apparatus is provided. The apparatus may be a communication apparatus or a sensing apparatus. The apparatus includes a processor. The processor is configured to perform any method according to the first aspect. There may be one or more processors. The apparatus may further include a memory. The memory is configured to store computer instructions. When the processor executes the instructions, the apparatus is caused to perform any method according to the first aspect. The memory may be coupled to the processor, or may be independent of the processor. The apparatus may further include a communication interface. The communication interface is configured to communicate with a module outside the apparatus.

The apparatuses in the second aspect, the third aspect, and the fourth aspect may be the receiving device in the first aspect or an apparatus included in the receiving device, for example, a chip or a chip system. When the apparatus is a chip, a sending action/function of the apparatus may be understood as outputting information, and a receiving action/-function of the apparatus may be understood as inputting information.

According to a fifth aspect, a computer-readable storage medium is provided. The computer-readable storage medium stores a computer program or instructions. When the computer program or the instructions are run on an apparatus, the apparatus is caused to perform any method according to the first aspect. The apparatus may be a communication apparatus or a sensing apparatus.

According to a sixth aspect, a computer program product including instructions is provided. When the computer program product runs on an apparatus, the apparatus is caused to perform any method according to the first aspect. The apparatus may be a communication apparatus or a sensing apparatus.

For technical effects brought by any one of the designs of the second aspect to the sixth aspect, refer to the technical effects brought by the different designs of the first aspect. Details are not described herein again.

## BRIEF DESCRIPTION OF DRAWINGS

FIG. 1 is a diagram of a comb structure according to this application;
FIG. 2 is a schematic flowchart of signal receiving according to this application;
FIG. 3 is a diagram of a structure of a communication system according to this application;
FIG. 4 is a schematic flowchart of a signal receiving method according to this application;
FIG. 5 is a diagram of a comb structure or an interlace structure according to this application;
FIG. 6 is a schematic flowchart of signal receiving according to this application;
FIG. 7 is another schematic flowchart of signal receiving according to this application;
FIG. 8 is still another schematic flowchart of signal receiving according to this application;
FIG. 9 is yet another schematic flowchart of signal receiving according to this application;
FIG. 10 is a diagram of positions of sampling points according to this application;
FIG. 11 is a diagram of a structure of a communication apparatus according to this application;
FIG. 12 is a diagram of a structure of another communication apparatus according to this application;
FIG. 13 is a diagram of a structure of still another communication apparatus according to this application; and
FIG. 14 is a diagram of a structure of yet another communication apparatus according to this application.

## DESCRIPTION OF EMBODIMENTS

In descriptions of this application, unless otherwise specified, "/" represents an "or" relationship between associated objects. For example, A/B may represent A or B. In this application, "and/or" describes only an association relationship between associated objects, and represents that three relationships may exist. For example, A and/or B may represent the following three cases: Only A exists, both A and B exist, and only B exists, where A and B may be singular or plural.

In addition, in the descriptions of this application, unless otherwise specified, "a plurality of" means two or more. "At least one of the following items (pieces)" or a similar expression thereof means any combination of these items, including a singular item (piece) or any combination of plural items (pieces). For example, at least one item (piece) of a, b, and (or) c may indicate a, b, c, a and b, a and c, b and c, or a, b, and c, where a, b, and c may be singular or plural.

In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference.

In addition, in embodiments of this application, the term "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

It may be understood that an "embodiment" used throughout this specification means that particular features, structures, or characteristics related to this embodiment are included in at least one embodiment of this application. Therefore, embodiments in the entire specification are not necessarily a same embodiment. In addition, these particular features, structures, or characteristics may be combined in one or more embodiments by using any appropriate manner. It may be understood that sequence numbers of the processes do not mean execution orders in various embodiments of this application. The execution order of the processes should be determined based on functions and internal logic of the processes, and should not be construed as any limitation on implementation processes of embodiments of this application.

It may be understood that, in this application, "when", "at the time", "at that time when", and "if" mean that corresponding processing is performed in an objective situation, are not intended to limit time, do not require a determining action during implementation, and do not mean any other limitation.

It may be understood that, in some scenarios, some optional features in embodiments of this application may be independently implemented without depending on another feature, for example, a solution on which the optional features are currently based, to resolve a corresponding technical problem and achieve corresponding effects. Alternatively, in some scenarios, the optional features may be combined with another feature based on a requirement. Correspondingly, an apparatus provided in embodiments of this application may also correspondingly implement these features or functions. Details are not described herein.

In this application, unless otherwise specified, for same or similar parts of embodiments, mutual reference may be made between the embodiments. In embodiments of this application, unless otherwise specified or a logical conflict occurs, terms and/or descriptions in different embodiments are consistent and may be referenced by each other, and different embodiments may be combined based on internal logical relationships between the embodiments to form a new embodiment. The following implementations of this application do not constitute a limitation on the protection scope of this application.

Wireless sensing is an important technology in the future. In wireless sensing, a sending device may send a specific signal (referred to as a sent signal), and a receiving device may receive a signal (referred to as a received signal) obtained through reflection of the sent signal by an environment. Then, a transceiver device may compare an association relationship between the received signal and the sent signal, to analyze related information about the ambient environment, for example, analyze whether there is a to-be-detected or to-be-sensed object in the ambient environment, a distance between a scatterer and the transceiver device, an orientation or an angle of the scatterer relative to the transceiver device, and a moving speed of the scatterer relative to the transceiver device.

Wireless sensing may be widely applied to various fields. For example, in a vehicle-to-everything scenario, a vehicle may obtain, through wireless sensing, information about an ambient environment, for example, position information and speed information of a moving object like another vehicle or a pedestrian, and information about a relatively static object like a road surface or a fence. For another example, in an environment like an airport, a special device may be deployed to sense and monitor a flight object like an unmanned aerial vehicle, so that another flight object does not cause security impact on take-off and landing of an aircraft. For another example, in a home environment, intruder detection may be performed through wireless sensing, to improve security and privacy of the home environment.

Wireless sensing may be implemented by using a frequency-modulated continuous wave (frequency-modulated continuous wave, FMCW), a pulse waveform, an orthogonal frequency division multiplexing (orthogonal frequency domain multiplexing, OFDM) waveform, or the like. In the future, wireless sensing may be an important part of a future mobile communication system. To implement harmonious coexistence of communication and sensing and sharing of radio frequency and baseband devices, in the mobile communication system, it may be considered that a waveform that is the same as a communication waveform is used to implement wireless sensing, in other words, the OFDM waveform is used to implement wireless sensing.

In the OFDM waveform, a time-frequency resource may be divided into different subcarriers in frequency domain, and may be divided into different OFDM symbols in time domain. Further, in a cyclic prefix (cyclic prefix, CP)-OFDM waveform, the OFDM symbol in time domain includes a CP, which is used to resist multipath delay spread.

In addition, the time-frequency resource may be divided into a time-frequency resource grid. In the OFDM waveform, a minimum time-frequency resource unit is a resource element (resource element, RE). One RE includes one subcarrier in frequency domain and one OFDM symbol in time domain. Generally, a length (excluding a CP) of one OFDM symbol is inversely proportional to a subcarrier spacing. To be specific, if the subcarrier spacing is $\Delta f_c$, the length of the OFDM symbol is $T = 1/\Delta f_c$.

In wireless sensing, a signal having a large bandwidth usually needs to be used to sense the ambient environment. This is because, theoretically, a larger bandwidth indicates a higher delay resolution of a reflection path caused by the scatterer and indicates better sensing performance. In a wireless sensing scenario based on the OFDM waveform, a sensing device may send a signal in a comb (comb) manner or an interlace (interlace) manner. For example, the CP-OFDM waveform is used as an example. As shown in FIG. 1, one subcarrier in every M (for example, M=2) consecutive subcarriers may be used by the sensing device to send a sensing signal, and the other subcarriers in the M consecutive subcarriers may be used by another sensing device or communication device to send a signal.

When the sensing signal is sent in the comb or interlace manner, the sensing signal may have a large bandwidth, and the sensing signal occupies a small quantity of subcarriers in the bandwidth, so that the other subcarriers may be used by the another sensing device or the communication device, thereby increasing user capacities in a sensing system and a communication system.

Currently, a signal receiving process based on the OFDM waveform is shown in FIG. 2. For example, a receiver operates in a band with a bandwidth of $B = N\Delta f_c$, where $\Delta f_c$ represents a subcarrier spacing, and $N$ represents a total quantity of subcarriers included in the bandwidth. Refer to FIG. 2. The receiver first receives a time domain analog signal with a bandwidth of $B = N\Delta f_c$, and then inputs the time domain analog signal into an analog-to-digital converter (analog-to-digital converter, ADC) to sample the analog signal, so as to obtain a time domain digital signal.

The time domain digital signal obtained through sampling is usually a serial signal. Therefore, the receiver may perform serial-to-parallel (sequence to parallel, S->P) conversion. After fast Fourier transform (fast Fourier transform, FFT) is performed on a converted signal, a frequency domain digital signal (which may also be understood as a signal received value on each subcarrier) may be obtained. The frequency domain digital signal includes signals on all subcarriers on the bandwidth. When the sensing signal is sent in the comb or interlace manner, the receiver needs to extract a signal on a subcarrier corresponding to a comb or an interlace to obtain the sensing signal, and then perform subsequent processing based on the sensing signal.

In the foregoing process, during sampling, according to a Nyquist sampling theorem, a sampling frequency needs to be greater than or equal to the signal bandwidth $B$; otherwise, a sampled digital signal is a signal obtained through aliasing of an original signal in frequency domain, affecting receiving performance. In addition, a quantity of FFT points needs to be greater than or equal to a total quantity $N$ of subcarriers included in the signal bandwidth.

However, a higher sampling frequency of the ADC indicates higher costs of the ADC and lower sampling precision. In addition, due to limited quantization precision of the ADC, additional quantization noise is usually generated after a signal passes through the ADC. The quantization noise generally depends on a quantity of quantization bits of the ADC and a peak power of a signal input to the ADC. In the foregoing signal receiving process, when frequency division multiplexing is performed, on a same OFDM symbol, on a sensing signal to be received by the receiver and a signal of another user, the peak power of the signal input to the ADC is a sum of powers of the sensing signal and the signal of the another user. If the power of the signal of the another user is excessively high, the quantization noise generated after the signal passes through the ADC is also large, and even a problem of ADC blocking (blocking) is caused, in other words, a power of the quantization noise is far greater than a power of a target sensing signal, affecting receiving performance.

Based on this, this application provides a signal receiving method. When a target signal is sent in a comb manner or an interlace manner, time domain extension may be performed on a received signal (including the target signal and a signal of another user), and time domain signals obtained through extension are superposed, to obtain a time domain aliased signal. Then, the time domain aliased signal is sampled to obtain the target signal. Performing sampling in frequency domain is equivalent to performing periodic extension on a signal in time domain, and extracting the target signal from an entire bandwidth may be understood as sampling in frequency domain. Therefore, after extension and aliasing are performed in time domain, it may be considered that the target signal has been extracted. In this case, a signal input to an ADC does not include a signal of another user. In other words, a peak power of the signal input to the ADC is a power of the target signal, and does not include a power of the signal of the another user. In this way, the peak power of the signal input to the ADC can be reduced, so as to reduce quantization noise and improve signal receiving performance.

The technical solutions in embodiments of this application may be applied to various systems. The system may be a 3rd generation partnership project (3rd generation partnership project, 3GPP) system, for example, a 5th generation (5th generation, 5G) or 6th generation (6th generation, 6G) mobile communication system, a sidelink (sidelink, SL) system, an ultra-wideband (ultra-wideband, UWB) system, a vehicle-to-everything (vehicle-to-everything, V2X) system, a device-to-device (device-to-device, D2D) communication system, a machine-to-machine (machine to machine, M2M) communication system, an internet of things (internet of things, IoT), or another next generation communication system. The communication system may alternatively be a non-3GPP communication system, for example, a wireless local area network (wireless local area network, WLAN) system like Wi-Fi. This is not limited.

The technical solutions in embodiments of this application may be applied to sensing or communication in various scenarios, for example, may be applied to sensing or communication in one or more scenarios such as smart home, D2D, V2X, and IoT.

The foregoing systems and scenarios applicable to this application are merely examples for description. Systems and scenarios applicable to this application are not limited thereto. This is uniformly described herein. Details are not described below again.

FIG. 3 shows a system according to an embodiment of this application. The system includes a sending device and a receiving device. The system may be a communication system, a sensing system, or an integrated sensing and communication system.

In a possible implementation, in the sensing system or the integrated sensing and communication system, the sending device and the receiving device may be a same device, that is, in a self-sending and self-receiving scenario; or the sending device and the receiving device may be different devices, that is, in a self-sending and other-receiving scenario. In the communication system, the sending device and the receiving device may be different devices.

In a possible implementation, both the sending device and the receiving device may be terminal devices, or both may be network devices. Alternatively, one of the sending device and the receiving device may be a terminal device, and the other may be a network device. This is not specifically limited in this application. Alternatively, the sending device and/or the receiving device may be a sensing device, for example, a radar, or a device having a radar function.

Optionally, the receiving device may be a communication apparatus or a sensing apparatus. The communication apparatus may have a channel coding capability and a channel modulation/demodulation capability. Further, the communication apparatus may have a sensing capability. The sensing apparatus may have a sensing capability. Further, the sensing apparatus may not have a channel coding capability or a channel modulation/demodulation capability, or may have a channel coding capability and a channel modulation/demodulation capability. This is not limited.

In embodiments of this application, the terminal device may be a user side device having a wireless transceiver function, or may be a chip or chip system disposed in the device. The terminal device may also be referred to as user equipment (user equipment, UE), a terminal, an access terminal, a subscriber unit, a subscriber station, a mobile station (mobile station, MS), a remote station, a remote terminal, a mobile terminal (mobile terminal, MT), a user terminal, a wireless communication device, a user agent, a user apparatus, or the like. The terminal device may be, for example, a terminal device in IoT, V2X, D2D, M2M, a 5G network, or a future evolved public land mobile network (public land mobile network, PLMN). The terminal device may be deployed on land, including an indoor device, an outdoor device, a handheld device, or a vehicle-mounted device; may be deployed on a water surface (for example, on a ship); or may be deployed in the air (for example, on an aircraft, a balloon, or a satellite).

For example, the terminal device may be an unmanned aerial vehicle, an IoT device (for example, a sensor, an electricity meter, or a water meter), a V2X device, a station (station, ST) in a wireless local area network (wireless local area network, WLAN), a cellular phone, a cordless phone, a session initiation protocol (session initiation protocol, SIP) phone, a wireless local loop (wireless local loop, WLL) station, a personal digital processing (personal digital assistant, PDA) device, a handheld device having a wireless communication function, a computing device, another processing device connected to a wireless modem, a vehicle-mounted device, a wearable device (which may also be referred to as a wearable intelligent device), a tablet computer, a computer having a wireless transceiver function, a virtual reality (virtual reality, VR) terminal, a wireless terminal in industrial control (industrial control), a wireless terminal in self-driving (self-driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), a vehicle-mounted terminal, a vehicle having a vehicle-to-vehicle (vehicle-to-vehicle, V2V) communication capability, an intelligent networked vehicle, or an unmanned aerial vehicle having an unmanned aerial vehicle (unmanned aerial vehicle, UAV) to unmanned aerial vehicle (UAV to UAV, U2U) communication capability. The terminal device may be mobile, or may be fixed. This is not specifically limited in this application.

In embodiments of this application, the network device may be a network side device having a wireless transceiver function, or may be a chip or chip system disposed in the device. The network device is located in a radio access network (radio access network, RAN) in a mobile communication system, and is configured to provide an access service for the terminal device. The network device may be an evolved NodeB (evolutional NodeB, eNB or eNodeB) in an LTE or evolved LTE (LTE-Advanced, LTE-A) system, for example, a conventional macro base station eNB and a micro base station eNB in a heterogeneous network scenario; may be a next generation NodeB (next generation NodeB, gNodeB or gNB) in a 5G system; may be a transmission reception point (transmission reception point, TRP); may be a base station in a future evolved PLMN; may be a broadband network service gateway (broadband network gateway, BNG), an aggregation switch, or a non-3GPP access device; may be a radio controller in a cloud radio access network (cloud radio access network, CRAN); may be an access node (access point, AP) in a Wi-Fi system; may be a wireless relay node or a wireless backhaul node; or may be a device that implements a base station function in IoT, V2X, D2D, or M2M. This is not specifically limited in embodiments of this application. For example, the base station in embodiments of this application may include base stations in various forms, for example, a macro base station, a micro base station (also referred to as a small cell), a relay station, and an access point. This is not specifically limited in embodiments of this application.

In some implementation scenarios, the network device may alternatively be a module or unit that can implement some or all functions of the base station. For example, the network device may be a central unit (central unit, CU), a distributed unit (distributed unit, DU), a CU and a DU, a CU-control plane (control plane, CP), a CU-user plane (user plane, UP), or a radio unit (radio unit, RU). The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or the CU-CP and the CU-UP), the DU, or the RU may alternatively have different names, but a person skilled in the art may understand meanings thereof. For example, the network device may be a network device in an open radio access network (open RAN, ORAN) system or a module of the network device. In the ORAN system, the CU may also be referred to as an open (open, O)-CU, the DU may also be referred to as an O-DU, the CU-CP may also be referred to as an O-CU-CP, the CU-UP may also be referred to as an O-CU-UP, and the RU may also be referred to as an O-RU. Any one of the CU (or the CU-CP or the CU-UP), the DU, and the RU in this application may be implemented by using a software module, a hardware module, or a combination of a software module and a hardware module.

In some implementation scenarios, the network device may also be referred to as a RAN node, a RAN device, or an access network device, or the network device may be named in another manner. This is not specifically limited in this application.

All or some functions of the terminal device or the network device in this application may alternatively be implemented through a software function running on hardware, or implemented through a virtualized function instantiated on a platform (for example, a cloud platform). The terminal device or the network device in this application may alternatively be a logical node, a logical module, or software that can implement all or some functions of the terminal device or the network device.

With reference to the accompanying drawings, the following describes in detail a signal receiving method provided in embodiments of this application by using interaction between the sending device and the receiving device shown in FIG. 3 as an example.

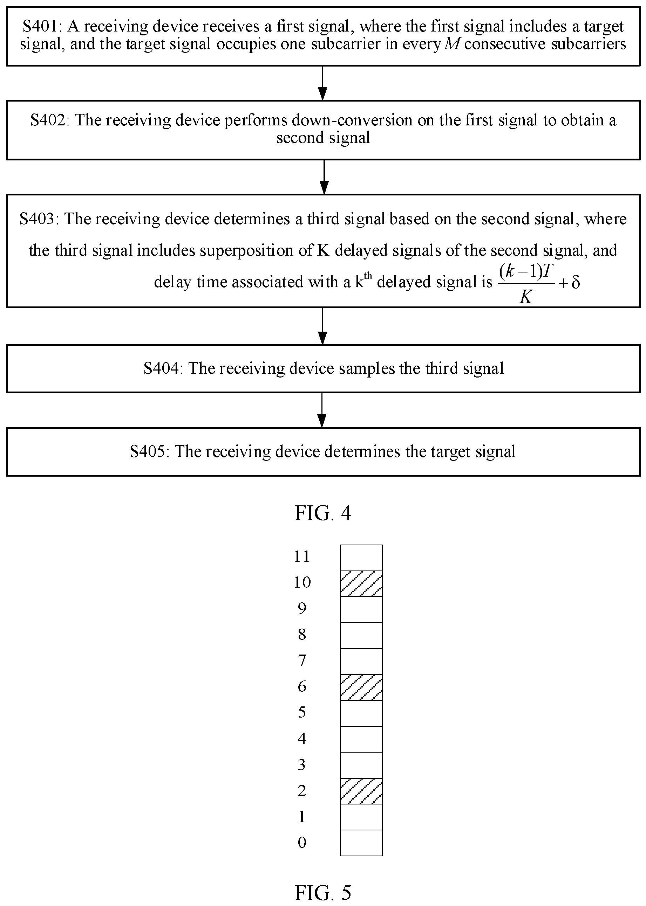

FIG. 4 is a schematic flowchart of a signal receiving method according to an embodiment of this application. The signal receiving method includes the following steps.

S401: A receiving device receives a first signal.

A bandwidth of the first signal is $B$. The first signal includes a target signal. The target signal occupies one subcarrier in every $M$ consecutive subcarriers, and $M$ is a positive integer greater than 1.

For example, the first signal may be sent by another sending device. In this scenario, it may be considered that a sending device and the receiving device are different devices. Alternatively, the first signal may be a signal obtained through reflection, by an environment, of a signal sent by the receiving device. In this scenario, it may be considered that a sending device and the receiving device are a same device. This is not limited in embodiments of this application.

In a possible implementation, the target signal occupies one subcarrier in every $M$ consecutive subcarriers in the bandwidth $B$. Specifically, the target signal may occupy one subcarrier at intervals of $M - 1$ consecutive subcarriers in the bandwidth $B$. In other words, it may be considered that the target signal is distributed in a comb manner or an interlace manner in the bandwidth $B$, or that the target signal is mapped in the comb or interlace manner in the bandwidth $B$. A comb index (which may also be understood as an interlace index) associated with the target signal may be determined based on a position of the subcarrier occupied by the target signal, and the position of the subcarrier occupied by the target signal may also be determined based on the comb index associated with the target signal. For example, assuming that subcarriers in the bandwidth $B$ may be respectively associated with indexes 0, 1, 2, . .., when the target signal occupies subcarriers 0, $M$, $2M$, ..., a comb index or an interlace index associated with the target signal may be 0, or when a comb index associated with the target signal is 0, the target signal occupies subcarriers 0, $M$, $2M$,...; when the target signal occupies subcarriers 1, $M + 1$, $2M + 1$,..., a comb index or an interlace index associated with the target signal may be 1; and so on. As shown in FIG. 5, for example, $M = 4$. The target signal occupies one subcarrier in every four consecutive subcarriers, the target signal occupies subcarriers 2, 6, 10, . .., and a comb index or an interlace index associated with the target signal is 2.

In a possible implementation, $M$ may also be understood as a comb number. The subcarrier occupied by the target signal may also be understood as an interlace in which the target signal is located.

In a possible implementation, in the bandwidth, another subcarrier other than the subcarrier occupied by the target signal may carry a signal of another user or device. For example, in FIG. 5, a comb 0 (including subcarriers 0, 4, 8, ...),

a comb 1 (including subcarriers 1, 5, 9, ...), and a comb 3 (including subcarriers 3, 7, 11, ...) in the bandwidth *B* may be respectively used to carry signals of other three users.

S402: The receiving device performs down-conversion on the first signal to obtain a second signal.

In a possible implementation, a frequency $f_c$ of the down-conversion is the same as a carrier frequency $f_0$ of the first signal.

In a possible implementation, a frequency $f_c$ of the down-conversion is related to a carrier frequency $f_0$ of the first signal and/or a position of the target signal. For example, the frequency of the down-conversion may be the same as a frequency of a subcarrier included (or occupied) by the target signal.

In an example, the frequency of the down-conversion may be a frequency of a center subcarrier of the target signal. For example, the target signal occupies *Y* subcarriers. When *Y* is an odd number, the center subcarrier of the target signal is a $\lceil Y/2 \rceil^{th}$ subcarrier in the *Y* subcarriers, and $\lceil \rceil$ represents rounding up. When *Y* is an even number, the center subcarrier of the target signal is a $(Y/2)^{th}$ or $(Y/2+1)^{th}$ subcarrier in the *Y* subcarriers. Based on the example shown in FIG. 5, if the target signal occupies only subcarriers 2, 6, *and* 10, the center subcarrier is the subcarrier 6; or if the target signal occupies subcarriers 2, 6, 10, *and* 14, the center subcarrier is the subcarrier 6 or 10.

In another example, the frequency of the down-conversion may be a frequency of a subcarrier that is in subcarriers included in the target signal and that is closest to a subcarrier corresponding to the carrier frequency $f_0$. In a special case, if a frequency of one subcarrier in the subcarriers included in the target signal is the same as the carrier frequency $f_0$, or includes the carrier frequency $f_0$, the frequency of the down-conversion may be the carrier frequency $f_0$. Based on the example shown in FIG. 5, if the carrier frequency $f_0$ is a frequency of the subcarrier 5, a subcarrier whose frequency is closest to the carrier frequency is the subcarrier 6, and the frequency of the down-conversion is a frequency of the subcarrier 6.

In still another example, the frequency of the down-conversion may be a frequency of a subcarrier that is closest to a subcarrier corresponding to the carrier frequency $f_0$ and that is in subcarriers that are included in the target signal and whose frequencies are greater than (or greater than or equal to) the carrier frequency. In a special case, if a frequency of one subcarrier in the subcarriers included in the target signal is the same as the carrier frequency $f_0$, or includes the carrier frequency $f_0$, the frequency of the down-conversion may be the carrier frequency $f_0$. Based on the example shown in FIG. 5, if the carrier frequency $f_0$ is a frequency of the subcarrier 5, in the subcarriers occupied by the target signal, subcarriers whose frequencies are greater than the carrier frequency include the subcarrier 6 and the subcarrier 10, and a subcarrier whose frequency is closest to the carrier frequency is the subcarrier 6. Therefore, the frequency of the down-conversion is a frequency of the subcarrier 6.

In yet another example, the frequency of the down-conversion may be a frequency of a subcarrier that is closest to a subcarrier corresponding to the carrier frequency $f_0$ and that is in subcarriers that are included in the target signal and whose frequencies are less than (or less than or equal to) the carrier frequency. In a special case, if a frequency of one subcarrier in the subcarriers included in the target signal is the same as the carrier frequency $f_0$, or includes the carrier frequency $f_0$, the frequency of the down-conversion may be the carrier frequency $f_0$. Based on the example shown in FIG. 5, if the carrier frequency $f_0$ is a frequency of the subcarrier 5, in the subcarriers occupied by the target signal, a subcarrier whose frequency is less than the carrier frequency includes the subcarrier 2, and a subcarrier whose frequency is closest to the carrier frequency is the subcarrier 2. Therefore, the frequency of the down-conversion is a frequency of the subcarrier 2.

Optionally, a frequency of a subcarrier in this embodiment of this application may be understood as a center frequency of the subcarrier, a start frequency of the subcarrier, an end frequency of the subcarrier, or another frequency included in the subcarrier.

In a possible implementation, performing down-conversion on the first signal may include: multiplying the first signal by a single-frequency signal, where a frequency of the single-frequency signal is the frequency of the down-conversion. For example, the frequency of the down-conversion is $f_c$. The single-frequency signal may be represented as $y(t) = \exp(-2\pi j f_c t)$, where t represents time.

The single-frequency signal is represented in a complex number form. There is no complex-number-domain signal in the physical world. Therefore, during actual implementation, the first signal may be separately multiplied by $cos(2\pi f_c t)$ and $sin(2\pi f_c t)$, and then an **I** signal and a **Q** signal are separately obtained by using a low-pass filter. In other words, the second signal may include the **I** signal and the **Q** signal.

Optionally, when the frequency of the down-conversion is $f_c$, down-conversion may be performed on the first signal once to obtain the second signal, and the frequency of the down-conversion this time is $f_c$. Alternatively, down-conversion at the frequency of $f_0$ may be first performed on the first signal to obtain an intermediate signal, and then down-conversion at a frequency of $f_c - f_0$ is performed on the intermediate signal to obtain the second signal.

After the down-conversion, a radio frequency signal (that is, the first signal) having a high frequency may be shifted to a baseband for processing. In addition, the frequency of the down-conversion is determined based on the carrier frequency of the first signal and the position of the target signal, and the target signal may be aligned with a baseband zero frequency after the down-conversion, to facilitate subsequent processing.

S403: The receiving device determines a third signal based on the second signal.

The third signal includes superposition of $K$ delayed signals of the second signal.

Delay time associated with a $k^{th}$ delayed signal in the $K$ delayed signals is $\frac{(k-1)T}{K} + \delta$. $T$ is a time length of the first signal, $k$ = 1, 2,..., or $K$, $\delta$ is greater than or equal to 0, and $K$ is a positive integer greater than or equal to $M$.

In a possible implementation, delay time associated with a delayed signal of the second signal may be understood as follows: The delayed signal may be obtained by delaying the second signal by the delay time. For example, delaying a signal may also be understood as shifting the signal backward in time domain.

In a possible implementation, the time length of the first signal is a length of one OFDM symbol. In other words, the first signal may be understood as a signal on one OFDM symbol. The length of one OFDM symbol may be a length of a part excluding a CP part, for example, $T$ = $1/\Delta f_c$. When the receiving device receives signals on a plurality of OFDM symbols, a signal on each OFDM symbol may be understood as the first signal. In other words, a received signal on each OFDM symbol is applicable to the signal receiving method provided in this embodiment of this application.

In a possible implementation, a value of $k$ may alternatively start from 0, that is, $k$ = 0, 1, 2,..., or $K$ - 1. In this scenario, the delay time associated with the $k^{th}$ delayed signal is $\frac{kT}{K} + \delta$, and parts related to $k$ in texts and formulas in the subsequent embodiments may be adaptively adjusted accordingly. In the following embodiments of this application, an example in which $k$ = 1, 2, ... , or $K$ is used for description.

In a possible implementation, $K = M$; or $K = M - 1 + C$, where $C$ is a positive integer, and further, $C$ is a positive integer less than or equal to $M$. For example, $C = M$, that is, $K = 2M - 1$.

It may be understood that the first signal, the second signal, and the third signal are described from a perspective of a time domain analog signal.

In a possible implementation, sampling a signal in frequency domain is equivalent to performing periodic extension on the signal in time domain, and extracting the target signal from an entire bandwidth may be understood as sampling in frequency domain. Accordingly, in time domain, this may be equivalent to performing periodic extension in time domain. An aliased signal may be obtained by superposing signals obtained through periodic extension. After discrete Fourier transform (discrete Fourier transform, DFT) is performed on a sequence including time domain sampling points of the aliased signal in one period, a discrete frequency domain sequence number or a discrete frequency domain sequence corresponding to the target signal is obtained. In other words, a signal of the aliased signal in one period may be determined by using the third signal, and the discrete frequency domain sequence number or the discrete frequency domain sequence corresponding to the target signal may be further determined. That is, after determining the third signal, the receiving device may perform the following step S404 and step S405.

S404: The receiving device samples the third signal.

In a possible implementation, sampling the third signal may be understood as: converting the third signal from a time domain analog signal into a time domain digital signal (or referred to as a discrete time domain signal or a discrete time domain sequence).

In a possible implementation, an $N/M$-point discrete time domain sequence may be obtained by sampling the third signal in step S404. $N$ is greater than or equal to a quantity of subcarriers included in the bandwidth of the first signal, and $N$ is a positive integer. The $N/M$-point discrete time domain sequence may be understood as the time domain sampling points of the aliased signal in one period. In a special case, when $N/M$ is not an integer, $N/M$ may be rounded up or rounded down. In other words, an $\lceil N/M \rceil$ -point discrete time domain sequence or an $\lfloor N/M \rfloor$ -point discrete time domain sequence is obtained by sampling the third signal. In this embodiment of this application, that $N/M$ is an integer is mainly used for description.

S405: The receiving device determines the target signal. The target signal may be a discrete time domain signal or a discrete time domain sequence corresponding to the target signal, or may be a discrete frequency domain signal or a discrete frequency domain sequence corresponding to the target signal.

Optionally, when the target signal is the discrete time domain signal or the discrete time domain sequence corresponding to the target signal, the target signal may be obtained by sampling the third signal in step S404. Step S405 may not be performed. Alternatively, step S405 may be understood as: determining, as the target signal, the discrete time domain signal or the discrete time domain sequence obtained by sampling the third signal.

Optionally, when the target signal is the discrete frequency domain signal or the discrete frequency domain sequence corresponding to the target signal, the discrete time domain signal or the discrete time domain sequence obtained by sampling the third signal in step S404 is referred to as a first time domain sequence. That the receiving device may determine the target signal based on the first time domain sequence may also be understood as that the receiving device determines the discrete frequency domain signal or the discrete frequency domain sequence corresponding to the target signal.

In a possible implementation, the receiving device may perform $N/M$-point DFT on the first time domain sequence to obtain the target signal, in other words, to obtain the discrete frequency domain signal or the discrete frequency domain sequence corresponding to the target signal. $N$ is greater than or equal to a quantity of subcarriers included in the bandwidth of the first signal, and $N$ is a positive integer. In a special case, when $N/M$ is not an integer, $N/M$ may be rounded up or rounded down. In other words, $\lceil N/M \rceil$-point DFT or $\lfloor N/M \rfloor$-point DFT is performed. In this embodiment of this application, that $N/M$ is an integer is mainly used for description.

In a possible implementation, performing $N/M$-point DFT on the first time domain sequence may include: performing $N/M$-point FFT on the first time domain sequence, where FFT may be understood as a specific implementation of DFT.

In a possible implementation, performing $N/M$-point DFT on the first time domain sequence may be understood as performing $N/M$-point DFT on the sequence including the time domain sampling points of the aliased signal in one period.

Based on the foregoing solution, when the target signal is sent in a comb manner or an interlace manner, time domain extension may be performed on the received signal (that is, the first signal), and time domain signals obtained through extension are superposed, to obtain an aliased time domain signal. Then, the aliased time domain signal is sampled to obtain the target signal. Performing sampling in frequency domain is equivalent to performing periodic extension on a signal in time domain, and extracting the target signal from an entire bandwidth may be understood as sampling in frequency domain. Therefore, after extension and aliasing are performed in time domain, it may be considered that the target signal has been extracted. In this case, a signal input to an ADC does not include a signal of another user. In other words, a peak power of the signal input to the ADC is a power of the target signal, and does not include a power of the signal of the another user. In this way, the peak power of the signal input to the ADC can be reduced, so as to reduce quantization noise and improve signal receiving performance.

The foregoing describes an overall procedure of the signal receiving method provided in this embodiment of this application. The following describes in detail determining and sampling the third signal.

A manner of determining the third signal is as follows:

In a first possible implementation, determining the third signal based on the second signal may include: delaying the second signal $K$ times to obtain the $K$ delayed signals of the second signal, and superposing the $K$ delayed signals to obtain the third signal.

The delay time associated with the $k^{\text{th}}$ delayed signal is $\frac{(k-1)T}{K} + \delta$. In other words, the second signal may be delayed by $\delta$, $\frac{T}{K} + \delta$, $\frac{2T}{K} + \delta$, ..., and $\frac{(K-1)T}{K} + \delta$ respectively to obtain the $K$ delayed signals of the second signal.

In a possible implementation, when $\delta = 0$, the signal obtained by delaying the second signal by $\delta$ may be understood as the second signal. In other words, it may be considered that a $1^{\text{st}}$ delayed signal of the second signal is actually obtained without delaying the second signal. However, for brevity and consistency of expression, in this case, the $1^{\text{st}}$ delayed signal of the second signal is still referred to as a delayed signal of the second signal.

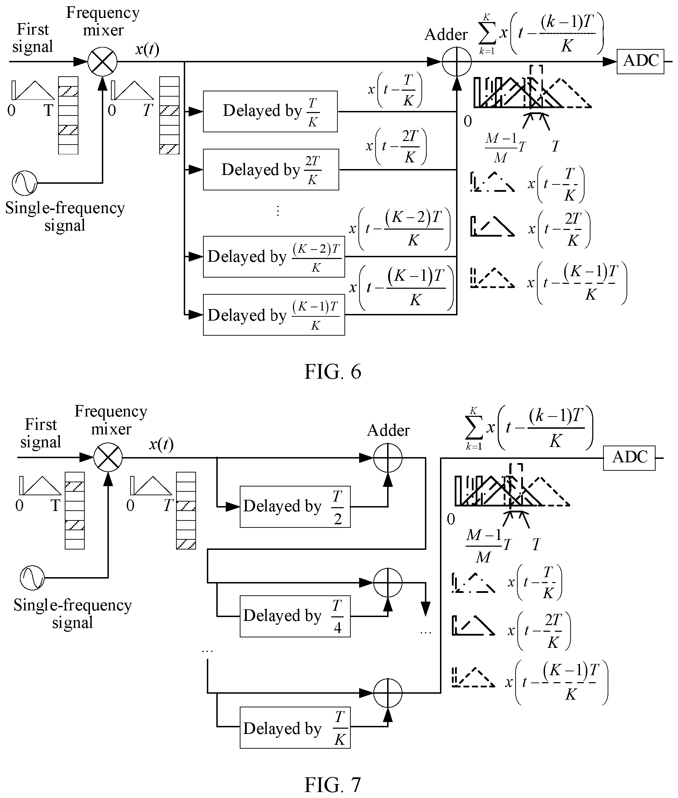

For example, $\delta = 0$ and $K = M = 4$. As shown in FIG. 6, after receiving the first signal, the receiving device inputs the first signal to a frequency mixer to perform down-conversion on the first signal, to obtain a second signal $x(t)$. Then, the second signal is delayed by 0, $\frac{T}{K}$, $\frac{2T}{K}$, ..., and $\frac{(K-1)T}{K}$ respectively to obtain $x(t)$, $x\left(t - \frac{T}{K}\right)$, $x\left(t - \frac{2T}{K}\right)$, ..., and $x\left(t - \frac{(K-1)T}{K}\right)$, and the $K$ signals are input to an adder for superposition to obtain the third signal. For example, the third signal may be represented as:

$$\sum_{k=1}^{K} x\left(t - \frac{(k-1)T}{K} - \delta\right).$$

A reference point of $t$ is start time of the first signal. In other words, a moment 0 corresponding to $t$ (or understood as a moment of $t = 0$) is the start time of the first signal.

Optionally, the start time of the first signal may be start time of a part excluding a CP part. For example, assuming that start time of an OFDM symbol (including a CP) in which the first signal is located is t1, start time of the CP is t1, and end time of the CP is t2, the start time of the first signal may be t2, in other words, a reference point of a first time range may be t2.

In a second possible implementation, determining the third signal based on the second signal may include: determining the third signal by using an $X$-stage circuit. In the $X$-stage circuit, an output signal of an $i^{\text{th}}$-stage circuit is a signal obtained by superposing an input signal of the $i^{\text{th}}$-stage circuit and a signal obtained by delaying the input signal of the $i^{\text{th}}$-stage circuit, where $i = 1, 2,..., $ or $X$, and $X$ is a positive integer greater than 1.

To be specific, the input signal of the $i^{th}$-stage circuit may be delayed to obtain a delayed signal of the input signal, and then the input signal and the delayed signal of the input signal are superposed to obtain the output signal.

When $i = 1$, the input signal of the $i^{th}$-stage circuit is a signal obtained by delaying the second signal by $\delta$. When $i > 1$ the input signal of the $i^{th}$-stage circuit is an output signal of an $(i - 1)^{th}$-stage circuit. The third signal is an output signal of an $X^{th}$-stage circuit. The output signal of the $X^{th}$-stage circuit includes superposition of the $K$ delayed signals of the second signal.

In a first possible implementation, when $K = 2^X$, the output signal of the $i^{th}$-stage circuit is a signal obtained by superposing the input signal of the $i^{th}$-stage circuit and a signal obtained by delaying the input signal of the $i^{th}$-stage circuit by $\frac{T}{2^i}$. For example, $\delta = 0$ and $K = M = 4$, as shown in FIG. 7.

When $i = 1$, an input signal of a $1^{st}$-stage circuit is a second signal $x(t)$, and a delayed signal $x\left(t - \frac{T}{2}\right)$ is obtained by delaying the second signal $x(t)$ by $\frac{T}{2}$. Therefore, an output signal of the $1^{st}$-stage circuit is $x(t) + x\left(t - \frac{T}{2}\right)$.

When $i = 2$, an input signal of a $2^{nd}$-stage circuit is the output signal of the $1^{st}$-stage circuit, that is, $x(t) + x\left(t - \frac{T}{2}\right)$, and a delayed signal $x\left(t - \frac{T}{4}\right) + x\left(t - \frac{3T}{4}\right)$ is obtained by delaying the input signal of the $2^{nd}$-stage circuit by $\frac{T}{2^2}$. Therefore, an output signal of the $2^{nd}$-stage circuit is

$$x(t) + x\left(t - \frac{T}{2}\right) + x\left(t - \frac{T}{4}\right) + x\left(t - \frac{3T}{4}\right).$$

By analogy, the output signal of the $X^{th}$-stage circuit (that is, the third signal) may be represented as $\sum_{k=1}^{K} x\left(t - \frac{(k-1)T}{K}\right)$.

In a second possible implementation, $K$ may be represented as a product of $X$ positive integers, that is, $K = \prod_{i=1}^{X} K_i$, where $\prod$ represents cumulative multiplication. $K_i$ is a positive integer, and further, $K_i$ is a positive integer greater than 1. In this scenario, the output signal of the $i^{th}$-stage circuit is a signal obtained by superposing the input signal of the $i^{th}$-stage circuit and signals obtained by respectively delaying the input signal of the $i^{th}$-stage circuit by $\frac{T}{\prod_{j=1}^{i} K_j}, \frac{2T}{\prod_{j=1}^{i} K_j}, ..., \text{and } \frac{(K_i-1)T}{\prod_{j=1}^{i} K_j}$. In other words, in the $i^{th}$-stage circuit, the input signal of the $i^{th}$-stage circuit may be delayed a plurality of times.

In the foregoing descriptions, $i = 1, 2, ... , or X$. In addition, a value of $i$ may alternatively start from 0, that is, $i = 0, 1, 2,..., or X - 1$. In this scenario, the output signal of the $i^{th}$-stage circuit is a signal obtained by superposing the input signal of the $i^{th}$-stage circuit and a signal obtained by delaying the input signal of the $i^{th}$-stage circuit by $\frac{T}{2^{i+1}}$, or a signal obtained by superposing the input signal of the $i^{th}$-stage circuit and signals obtained by respectively delaying the input signal of the $i^{th}$-stage circuit by $\frac{T}{\prod_{j=0}^{i} K_j}, \frac{2T}{\prod_{j=0}^{i} K_j}, ..., \text{and } \frac{(K_i-1)T}{\prod_{j=0}^{i} K_j}$. Parts related to i in texts and formulas in the subsequent embodiments may be adaptively adjusted accordingly. In the following embodiments of this application, an example in which $i = 1, 2, ... , or X$ is used for description.

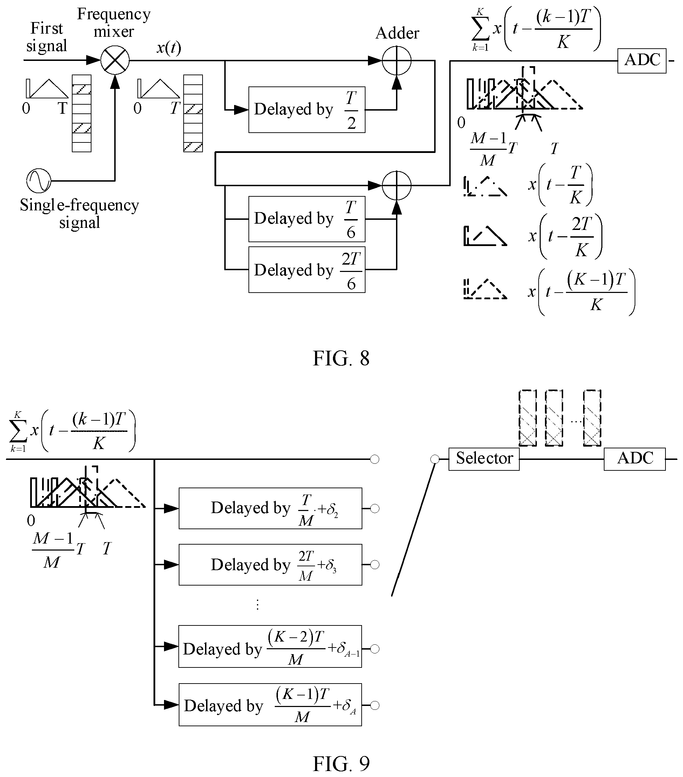

For example, $\delta = 0$, $K = 6$, $X = 2$, and $K_i = 2 \ or \ 3$, that is, $K = 2 \times 3$, as shown in FIG. 8.

When $i = 1, K_i = 2$, an input signal of a $1^{st}$-stage circuit needs to be delayed once, and associated delay time is $\frac{T}{2}$. The input signal of the $1^{st}$-stage circuit is a second signal $x(t)$, and a delayed signal $x\left(t - \frac{T}{2}\right)$ is obtained by delaying the second signal $x(t)$ by . Therefore, an output signal of the $1^{st}$-stage circuit is $x(t) + x\left(t - \frac{T}{2}\right)$.

When $i = 2, K_i = 3$, an input signal of a $2^{nd}$-stage circuit needs to be delayed twice, and associated delay time is $\frac{T}{6}$ and $\frac{2T}{6}$ respectively. The input signal of the $2^{nd}$-stage circuit is the output signal of the $1^{st}$-stage circuit, that is, $x(t) + x\left(t - \frac{T}{2}\right)$. A delayed signal $x\left(t - \frac{T}{6}\right) + x\left(t - \frac{4T}{6}\right)$ is obtained by delaying the input signal of the $2^{nd}$-

stage circuit by, and a delayed signal $x\left(t - \frac{2T}{6}\right) + x(t - \frac{5T}{6})$ obtained by delaying the input signal of the 2nd-stage

circuit by $\frac{2T}{6}$. Therefore, an output signal of the 2nd-stage circuit is

$$x(t) + x\left(t - \frac{T}{2}\right) + x\left(t - \frac{T}{6}\right) + x\left(t - \frac{4T}{6}\right) + x\left(t - \frac{2T}{6}\right) + x(t - \frac{5T}{6})$$ , that is,

$$x(t) + x\left(t - \frac{T}{6}\right) + x\left(t - \frac{2T}{6}\right) + x\left(t - \frac{3T}{6}\right) x\left(t - \frac{4T}{6}\right) + x(t - \frac{5T}{6})$$ , that is, $\sum_{k=1}^{K} x(t - \frac{(k-1)T}{K})$.

In a third possible implementation, the third signal may be determined by using a combination of the first possible implementation and the second possible implementation. In this scenario, $K$ may be represented as $K' + 2^X$. In this case, an intermediate signal 1 may be obtained first by using the first possible implementation, where the intermediate signal 1 is obtained by superposing $K'$ delayed signals of the second signal, and delay time associated with a $k$th ($k$ = 1, 2,..., or $K'$) delayed signal is $\frac{(k-1)T}{K} + \delta$. Then, the second signal is delayed by $\frac{K'T}{K} + \delta$ to obtain an intermediate signal 2, and the intermediate signal 2 is input to the $X$-stage circuit for further delay. The output signal of the $i$th-stage circuit is a signal obtained by superposing the input signal of the $i$th-stage circuit and a signal obtained by delaying the input signal of the $i$th-stage circuit by $\frac{(K-K')T}{2^i K}$, and the output signal of the $X$th-stage circuit is denoted as an intermediate signal 3. Finally, the intermediate signal 1 and the intermediate signal 3 are superposed to obtain the third signal.

Alternatively, the intermediate signal 3 may be obtained in the following manner: An intermediate signal 4 is obtained by using the second possible implementation, to be specific, the second signal is first input to the X-stage circuit, where the output signal of the $i$th-stage circuit is a signal obtained by superposing the input signal of the $i$th-stage circuit and the signal obtained by delaying the input signal of the $i$th-stage circuit by $\frac{(K-K')T}{2^i K}$, and the output signal of the $X$th-stage circuit is the intermediate signal 4. Then, the intermediate signal 3 may be obtained by delaying the intermediate signal 4 by $\frac{K'T}{K}$. The foregoing manner may also be extended to a case in which $K = K' + \prod_{i=1}^{X} K_i$, and details are not described herein again.

For example, $\delta = 0$, $K = 9$, $K' = 1$, and $X = 3$, that is, $K = 1 + 2^3$. The second signal $x(t)$ may be first delayed by 0 to obtain the intermediate signal 1, in other words, the intermediate signal 1 is the second signal $x(t)$, then the second signal is delayed by $\frac{T}{9}$ to obtain the intermediate signal 2, that is, $x\left(t - \frac{T}{9}\right)$, and then the intermediate signal 2 is delayed by using a three-stage circuit to obtain the intermediate signal 3. Delay time corresponding to the three-stage circuit are separately $\frac{4T}{9}, \frac{2T}{9}$, and $\frac{T}{9}$.

When $i$ = 1, an input signal of a 1st-stage circuit is $x\left(t - \frac{T}{9}\right)$, and a delayed signal $x\left(t - \frac{5T}{9}\right)$ is obtained by delaying the input signal by $\frac{4T}{9}$. Therefore, an output signal of the 1st-stage circuit is $x\left(t - \frac{T}{9}\right) + x\left(t - \frac{5T}{9}\right)$.

When $i$ = 2, an input signal of a 2nd-stage circuit is the output signal of the 1st-stage circuit, that is, $x\left(t - \frac{T}{9}\right) + x\left(t - \frac{5T}{9}\right)$, and a delayed signal $x\left(t - \frac{3T}{9}\right) + x\left(t - \frac{7T}{9}\right)$ is obtained by delaying the input signal of the 2nd-stage circuit by $\frac{2T}{9}$. Therefore, an output signal of the 2nd-stage circuit is $x\left(t - \frac{T}{9}\right) + x\left(t - \frac{5T}{9}\right) + x\left(t - \frac{3T}{9}\right) + x\left(t - \frac{7T}{9}\right)$.

When $i$ = 3, an input signal of a 3rd-stage circuit is the output signal of the 2nd-stage circuit, that is, $x\left(t - \frac{T}{9}\right) + x\left(t - \frac{3T}{9}\right) + x\left(t - \frac{5T}{9}\right) + x\left(t - \frac{7T}{9}\right)$, and a delayed signal $x\left(t - \frac{2T}{9}\right) + x\left(t - \frac{4T}{9}\right) + x\left(t - \frac{6T}{9}\right) + x\left(t - \frac{8T}{9}\right)$ is obtained by delaying the input signal of the 3rd-stage

circuit $\frac{T}{9}$. Therefore, an output signal of the 3rd-stage circuit (that is, the intermediate signal 3) is

$$x\left(t-\frac{T}{9}\right)+x\left(t-\frac{3T}{9}\right)+x\left(t-\frac{5T}{9}\right)+x\left(t-\frac{7T}{9}\right)+x\left(t-\frac{2T}{9}\right)+x\left(t-\frac{4T}{9}\right)+$$

$$x\left(t-\frac{6T}{9}\right)+x\left(t-\frac{8T}{9}\right).$$

A signal obtained by superposing the intermediate signal 1 and the intermediate signal 3 is

$$x(t)+x\left(t-\frac{T}{9}\right)+x\left(t-\frac{3T}{9}\right)+x\left(t-\frac{5T}{9}\right)+x\left(t-\frac{7T}{9}\right)+x\left(t-\frac{2T}{9}\right)+x\left(t-\frac{4T}{9}\right)+$$

$$x\left(t-\frac{6T}{9}\right)+x\left(t-\frac{8T}{9}\right), \text{ that is, } \sum_{k=1}^{9}x(t-\frac{(k-1)T}{9}).$$

It may be understood that there may be a plurality of manners to implement that "the third signal includes the superposition of the $K$ delayed signals of the second signal, and the delay time associated with the $k$th delayed signal in the $K$ delayed signals is $\frac{(k-1)T}{K}+\delta$". ". In addition, it is not required that each delayed signal of the second signal has a specific corresponding circuit (for example, in the foregoing second implementation, no delayed signal component is directly generated, but a finally generated signal is consistent with a required form). In other words, a specific manner of determining or obtaining the third signal is not limited in embodiments of this application.

For sampling of the third signal, there are the following implementations.

In a first possible implementation, when $K = M$, sampling the third signal may include: sampling the third signal within the first time range.

For example, the first time range may be one of the following: $[\frac{M-1}{M}T+\delta,T+\delta]$, $(\frac{M-1}{M}T+\delta,T+\delta]$, $[\frac{M-1}{M}T+\delta,T+\delta)$, or $(\frac{M-1}{M}T+\delta,T+\delta)$. The third signal within the first time range may be understood as a signal of the foregoing aliased signal in one period. For example, when the third signal is sampled within the first time range, and the first time domain range is $[\frac{M-1}{M}T+\delta,T+\delta]$, the sampled signal may be represented as:

$$\sum_{k=1}^{K}x\left(t-\frac{(k-1)T}{K}-\delta\right), where\ t\in[\frac{M-1}{M}T+\delta,T+\delta].$$

For example, as shown in FIG. 6 to FIG. 8, in signals output by the adder, a signal located in a dashed rectangle box is a sampled signal, or may be understood as a signal of the target signal in time domain.

A reference point of the first time range (or understood as a reference point of t) is the start time of the first signal. In other words, a moment 0 (or understood as a moment t=0) corresponding to the first time range is the start time of the first signal, or a time interval between start time of the first time range and the start time of the first signal is $\frac{M-1}{M}T+\delta$.

Optionally, for a part of the first signal that is outside the first time range (for example, including a CP part in an OFDM symbol in which the first signal is located), whether the receiving device samples the part may depend on an implementation of the receiving device. This is not specifically limited in this application. For example, the discrete time domain signal or the discrete time domain sequence obtained by sampling the third signal within the first time range is referred to as the first time domain sequence.

In a possible implementation, when the target signal is the discrete time domain signal or the discrete time domain sequence corresponding to the target signal, the first time domain sequence is the discrete time domain signal or the discrete time domain sequence corresponding to the target signal.

In another possible implementation, when the target signal is the discrete frequency domain signal or the discrete frequency domain sequence corresponding to the target signal, the receiving device may perform $N/M$-point DFT on the first time domain sequence to obtain the discrete frequency domain signal or the discrete frequency domain sequence corresponding to the target signal. $N$ is greater than or equal to the quantity of subcarriers included in the bandwidth of the first signal, and $N$ is a positive integer.

Based on the possible implementation, performing sampling in frequency domain is equivalent to performing periodic extension on a signal in time domain, and extracting the target signal from the entire bandwidth may be understood as sampling in frequency domain, and corresponds to (or is equivalent to) periodic extension in time domain.

A signal of the third signal within the first time domain range exactly corresponds to a signal of the signal obtained through periodic extension in one period. Therefore, when the third signal is sampled within the first time domain range, it may be considered that a signal input to the ADC does not include a signal of another user. In other words, a peak power of the signal input to the ADC is a peak power of the target signal, and does not include a power of the signal of the another user. In this way, the peak power of the signal input to the ADC can be reduced, so as to reduce quantization noise and improve signal receiving performance.

In addition, a length of the first time domain range may be $\frac{T}{M}$. In other words, within a time length $T$ of one OFDM symbol, duration in which the ADC used for sampling is turned on or operating is only required to be $\frac{T}{M}$. In comparison with a case in which the ADC is always turned on within the time length $T$, this case can reduce sampling power consumption of the ADC, to reduce power consumption of the receiving device.

In addition, based on the possible implementation, if a sampling rate for sampling the third signal within the first time range is $N\Delta f_C$, when the length of the first time domain range is $\frac{T}{M}$, the target signal includes $\frac{N}{M}$ sampling points in time domain. Subsequently, only $\frac{N}{M}$ -point DFT needs to be performed to obtain the frequency domain signal corresponding to the target signal. $N$ is greater than or equal to the quantity of subcarriers included in the bandwidth of the first signal, and $N$ is a positive integer. In comparison with a solution in which at least $N$-point DFT is performed on a signal on an entire OFDM symbol, this solution can reduce a quantity of DFT points, and reduce a capability requirement and costs for a DFT module (for example, an FFT module).

In a second possible implementation, when $K = M$, $A$ delayed signals of the third signal may be separately sampled, and then the target signal is determined based on sampling results of the $A$ delayed signals. $A$ is a positive integer, and further, $A$ is a positive integer less than or equal to $M$. In a special case, $A = M$. For example, as shown in FIG. 9, the following steps may be included.

(a) Delay the third signal $A$ times to obtain the $A$ delayed signals of the third signal, where delay time associated with an $a$th delayed signal is $\frac{(a-1)T}{M} + \delta_a$, $\delta_a$ is greater than or equal to 0, and $a = 1, 2,..., or A$. Similarly, a value of $a$ may alternatively be $0, 1,..., or A$ - $1$, and the delay time associated with the $a$th delayed signal is $\frac{aT}{M} + \delta_a$. Parts related to $a$ in texts and formulas in the subsequent embodiments may be adaptively adjusted accordingly. In the following embodiments of this application, an example in which $a = 1, 2, ... , or A$ is used for description.

In a possible implementation, when $a$ is in different values, values of $\delta_a$ may be the same or may be different. For example, when $a = 1$, $\delta_a$ may equal to 0; and when $a \neq 1$, $\delta_a$ may greater than or equal to 0.

(b) Sample the $a$th delayed signal of the third signal within a second time range. In other words, each delayed signal of the third signal is sampled. Different delayed signals of the third signal, that is, different values of $a$, correspond to different second time ranges.

In a possible implementation, a reference point of the second time range is the start time of the first signal. Refer to related descriptions of the first time range. Details are not described herein again.

In a possible implementation, the second time range corresponding to the $a$th delayed signal may be one of the following:

$$[\frac{M+a-2}{M}T + \delta + \sum_{j=1}^{a}\delta_j, \frac{M+a-1}{M}T + \delta + \sum_{j=1}^{a}\delta_j]$$ ,

$$(\frac{M+a-2}{M}T + \delta + \sum_{j=1}^{a}\delta_j, \frac{M+a-1}{M}T + \delta + \sum_{j=1}^{a}\delta_j]$$ , $$[\frac{M+a-2}{M}T + \delta + \sum_{j=1}^{a}\delta_j, \frac{M+a-1}{M}T + \delta +$$ $$\sum_{j=1}^{a}\delta_j)$$, or $$(\frac{M+a-2}{M}T + \delta + \sum_{j=1}^{a}\delta_j, \frac{M+a-1}{M}T + \delta + \sum_{j=1}^{a}\delta_j)$$ .

In a possible implementation, as shown in FIG. 9, the $A$ delayed signals of the third signal may be separately input to the ADC, by using a selector, at different moments (that is, different second time ranges) for sampling.

Optionally, a signal each delayed signal of the third signal within the second time range may also be understood as a signal of an aliased signal in one period (that is, a signal of the target signal in time domain, for example, a signal in a dashed-line box in FIG. 9), where the aliased signal is obtained by performing periodic extension and superposition on second signals. In other words, the target signal is copied $A$ times in time domain.

In a possible implementation, a sampling frequency used for sampling the $a$th delayed signal of the third signal is greater than or equal to $N\Delta f_C/A$; or a sampling frequency for the $a$th delayed signal of the third signal may be greater than or equal to *B/A*. *N* is greater than or equal to the quantity of subcarriers included in the bandwidth of the first signal, and *N* is a positive integer. $\Delta f_C$ is a bandwidth of the subcarrier, or a subcarrier spacing. *B* is the bandwidth of the first signal.

Optionally, $\frac{N}{AM}$-point sampling may be performed on the $a^{\text{th}}$ delayed signal of the third signal within the second time range. In other words, a sampling result obtained by sampling the $a^{\text{th}}$ delayed signal of the third signal within the second time range includes signals at $\frac{N}{AM}$ sampling points.

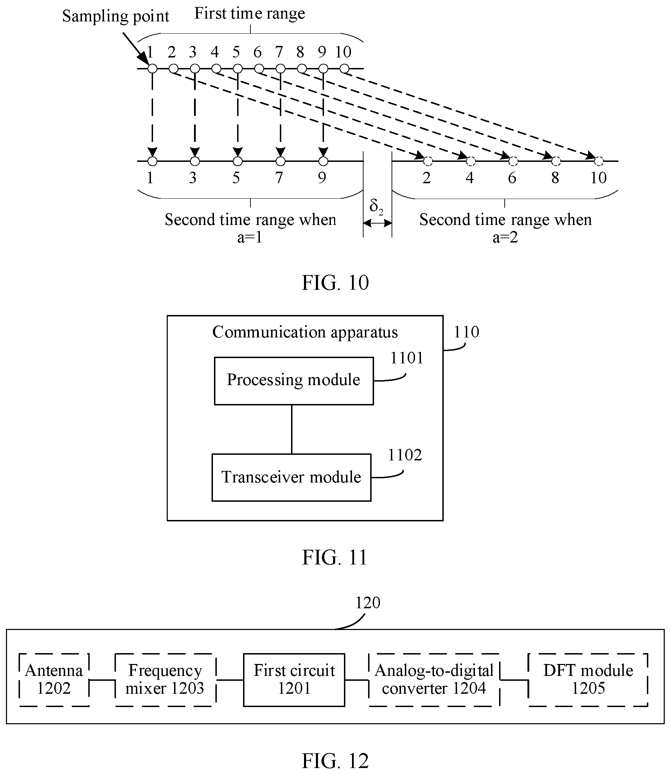

In a possible implementation, sampling positions of any two delayed signals in the *A* delayed signals of the third signal are different. For example, as shown in FIG. 10, in an example in which $\frac{N}{M} = 10$ and *A* = 2, 10 points originally need to be sampled for the third signal within the first time range. A sampling position of a 1$^{\text{st}}$ delayed signal of the third signal within a second time range 1 may correspond to 1$^{\text{st}}$, 3$^{\text{rd}}$, 5$^{\text{th}}$, 7$^{\text{th}}$, and 9$^{\text{th}}$ sampling points of the third signal within the first time range, and a sampling position of a 2$^{\text{nd}}$ delayed signal of the third signal within a second time range 2 may correspond to 2$^{\text{nd}}$ 4$^{\text{th}}$, 6$^{\text{th}}$, 8$^{\text{th}}$, and 10$^{\text{th}}$ sampling points of the third signal within the first time range.

In FIG. 10, an example in which $\delta_1 = 0$ and $\delta_2 \neq 0$ is used for description. Therefore, when the reference points of the first time range and the second time range are the same, and both are the start time of the first signal, start time of the second time range 1 and the first time range are the same, and a time interval between end time of the second time range 2 and the start time of the second time range 1 is $\delta_2$.

(c) Determine the target signal based on sampling results of the *A* delayed signals of the third signal.

Optionally, the sampling results of the *A* delayed signals of the third signal may be re-sorted to obtain the first time domain sequence. For example, the sampling results of the *A* delayed signals may be sequentially arranged from front to back according to a time domain order of sampling points that are of the third signal within the first time range and that correspond to actual sampling points within the second time range, to obtain the first time domain sequence.

For example, based on the example shown in FIG. 10, five sampling points may be obtained within the second time range 1, and five sampling points may be obtained within the second time range 2. Then, the 10 sampling points are re-sorted. For example, the two groups of five sampling points are interpolated, and the first time domain sequence may be a sampling result of a 1$^{\text{st}}$ sampling point within the second time range 1 (corresponding to a 1$^{\text{st}}$ sampling point within the first time range), a sampling result of a 1$^{\text{st}}$ sampling point within the second time range 2 (corresponding to a 2$^{\text{nd}}$ sampling point within the first time range), a sampling result of a 2$^{\text{nd}}$ sampling point within the second time range 1 (corresponding to a 3$^{\text{rd}}$ sampling point within the first time range), a sampling result of a 2$^{\text{nd}}$ sampling point within the second time range 2 (corresponding to a 4$^{\text{th}}$ sampling point within the first time range), a sampling result of a 3$^{\text{rd}}$ sampling point within the second time range 1 (corresponding to a 5$^{\text{th}}$ sampling point within the first time range), a sampling result of a 3$^{\text{rd}}$ sampling point within the second time range 2 (corresponding to a 6$^{\text{th}}$ sampling point within the first time range), a sampling result of a 4$^{\text{th}}$ sampling point within the second time range 1 (corresponding to a 7$^{\text{th}}$ sampling point within the first time range), a sampling result of a 4$^{\text{th}}$ sampling point within the second time range 2 (corresponding to an 8$^{\text{th}}$ sampling point within the first time range), a sampling result of a 5$^{\text{th}}$ sampling point within the second time range 1 (corresponding to a 9$^{\text{th}}$ sampling point within the first time range), and a sampling result of a 5$^{\text{th}}$ sampling point within the second time range 2 (corresponding to a 10$^{\text{th}}$ sampling point within the first time range).

In a possible implementation, when the target signal is the discrete time domain signal or the discrete time domain sequence corresponding to the target signal, the first time domain sequence is the discrete time domain signal or the discrete time domain sequence corresponding to the target signal.

In another possible implementation, when the target signal is the discrete frequency domain signal or the discrete frequency domain sequence corresponding to the target signal, the receiving device may perform *N/M*-point DFT on the first time domain sequence to obtain the discrete frequency domain signal or the discrete frequency domain sequence corresponding to the target signal.

Based on the possible implementation, the receiving device makes an additional copy of a signal of the target signal in time domain, and samples each copied signal at a frequency of $N\Delta f_C/A$. In comparison with a case of sampling at a frequency of $N\Delta f_C$, this case reduces the sampling frequency, to reduce a performance requirement and costs for the ADC.

In addition, based on the possible implementation, only $\frac{N}{M}$ sampling points are included in time domain. Subsequently, only $\frac{N}{M}$-point DFT needs to be performed to obtain the frequency domain signal corresponding to the target signal. In comparison with a solution in which at least *N*-point DFT is performed on a signal on an entire OFDM symbol, this solution can reduce a quantity of DFT points, and reduce a capability requirement and costs for a DFT module.

In a third possible implementation, when *K* = *M* - 1 + *C*, segment sampling may be performed on the third signal, and the target signal is determined based on a result of segment sampling. For example, the following steps may be included.

(a) Perform $C$ segments of sampling on the third signal.

A $c^{th}$ segment of sampling corresponds to a signal of the third signal within a third time range c, where c = 1, 2,..., or $C$. In other words, the third signal may be divided into $C$ segments of sub-signals in terms of time, and then the $C$ segments of sub-signals are separately sampled. A $c^{th}$ segment of sub-signal is a signal of the third signal within the third time range c.

The third time range $c$ may be one of the following: $[\frac{M+c-2}{M}T + \delta, \frac{M+c-1}{M}T + \delta]$ , $(\frac{M+c-2}{M}T + \delta, \frac{M+c-1}{M}T + \delta]$ , $[\frac{M+c-2}{M}T + \delta, \frac{M+c-1}{M}T + \delta)$ , or $(\frac{M+c-2}{M}T + \delta, \frac{M+c-1}{M}T + \delta)$ . A reference point of the third time range $c$ is the start time of the first signal. Refer to related descriptions of the first time range. Details are not described herein again.

Optionally, a value of $c$ may alternatively be 0, 1,..., or $C$ - 1, and the $c^{th}$ segment of sub-signal is a signal of the third signal within the third time range c. The third time range c may be one of the following:

$$[\frac{M+c-1}{M}T + \delta, \frac{M+c}{M}T + \delta], (\frac{M+c-1}{M}T + \delta, \frac{M+c}{M}T + \delta], [\frac{M+c-1}{M}T + \delta, \frac{M+c}{M}T + \delta) \quad , \quad \text{or}$$

$(\frac{M+c-1}{M}T + \delta, \frac{M+c}{M}T + \delta)$ . Parts related to c in texts and formulas in the subsequent embodiments may be adaptively adjusted accordingly. In the following embodiments of this application, an example in which $c$ = 1, 2, ... , or $C$ is used for description.

In a possible implementation, a sampling frequency for the $c^{th}$ segment of sampling of the third signal is greater than or equal to $N\Delta f_C/C$; or a sampling frequency for the $c^{th}$ segment of sampling of the third signal may be greater than or equal to $B/C$. $N$ is greater than or equal to the quantity of subcarriers included in the bandwidth of the first signal, and $N$ is a positive integer. $\Delta f_C$ is a bandwidth of the subcarrier, or a subcarrier spacing. $B$ is the bandwidth of the first signal.

Optionally, $\frac{N}{CM}$ -point sampling may be performed on the $c^{th}$ segment of sub-signal of the third signal within the third time range $c$. In other words, a sampling result obtained by sampling the $c^{th}$ segment of sub-signal of the third signal within the third time range $c$ includes signals at $\frac{N}{CM}$ sampling points.

In a possible implementation, sampling positions of any two sub-signals in the $C$ segments of sub-signals of the third signal are different. For example, $\frac{N}{M} = 10$ and $C$ = 2. 10 points originally need to be sampled for the third signal within the first time range. A sampling position of a 1$^{st}$ segment of sub-signal of the third signal within the third time range may correspond to 1$^{st}$, 2$^{nd}$, 3$^{rd}$ 4$^{th}$, and 5$^{th}$ sampling points of the third signal within the first time range, and a sampling position of a 2$^{nd}$ segment of sub-signal of the third signal within the third time range may correspond to 6$^{th}$, 7$^{th}$, 8$^{th}$, 9$^{th}$, and 10$^{th}$ sampling points of the third signal within the first time range. For specific details, refer to the related descriptions of "the sampling positions of any two delayed signals in the $A$ delayed signals of the third signal are different".

(b) Determine the target signal based on sampling results of the $C$ segments of sampling.

Optionally, the sampling results of the $C$ segments of sampling may be re-sorted to obtain the first time domain sequence. For example, the sampling results of the $C$ segments of sampling may be sequentially arranged from front to back according to a time domain order of sampling points that are of the third signal within the first time range and that correspond to actual sampling points within the third time range, to obtain the first time domain sequence. For specific details, refer to related descriptions of "re-sorting the sampling results of the $A$ delayed signals of the third signal to obtain the first time domain sequence".

In a possible implementation, when the target signal is the discrete time domain signal or the discrete time domain sequence corresponding to the target signal, the first time domain sequence is the discrete time domain signal or the discrete time domain sequence corresponding to the target signal.

In another possible implementation, when the target signal is the discrete frequency domain signal or the discrete frequency domain sequence corresponding to the target signal, the receiving device may perform $N/M$-point DFT on the first time domain sequence to obtain the discrete frequency domain signal or the discrete frequency domain sequence corresponding to the target signal.

Based on the possible implementation, the sampling frequency and the quantity of DFT points can also be reduced, so that capability requirements and costs for the ADC and the DFT module are reduced.

In a possible implementation, functions related to step S401 and step S402 may be implemented on a radio frequency, and functions related to step S403 to step S405 may be implemented on a baseband (for example, by using a baseband chip).

In this embodiment of this application, a method for dividing an input signal into a plurality of signals and then delaying some of the signals is mentioned a plurality of times. For example, the second signal is delayed $K$ times (as shown in FIG. 6), or the input signal of the $i^{th}$-stage circuit in the X-stage circuit is delayed (as shown in FIG. 7 and FIG. 8). In an actual system, a step of dividing a signal into a plurality of signals reduces amplitude or energy of the plurality of signals in comparison with the original signal. However, because amplitude or energy of each signal is an equal fraction of amplitude or energy of the source signal, receiving performance of a receiver is not affected. In addition, after the signal is divided into the plurality of signals, the plurality of signals may be amplified by using some amplifiers, so that average energy or amplitude of the plurality of signals is consistent with that of the original signal. Therefore, the foregoing amplitude or energy reduction is not considered in related mathematical expressions in this application, but the invention essence of the present invention is not affected.

It may be understood that, in embodiments of this application, the receiving device may perform some or all of the steps or operations in embodiments of this application. These steps or operations are merely examples. In embodiments of this application, other steps or operations or variations of the steps or operations may be further performed. In addition, the steps or operations may be performed in an order different from an order presented in embodiments of this application, and not all of the steps or operations in embodiments of this application may be performed. For example, when the receiving device has only a radio frequency processing function or only a baseband processing function, the receiving device may perform only some steps or operations that are performed by the receiving device and that are described in embodiments of this application. For example, when the receiving device has only the radio frequency processing function, only step S401 and step S402 are performed; and when the receiving device has only the baseband processing function, only step S403 to step S405 are performed, and other operations may be performed by at least one other device.

It may be understood that, in the foregoing embodiments, the methods and/or steps implemented by the receiving device may be alternatively implemented by a component (for example, a processor, a chip, a chip system, a circuit, a logical module, or software) that may be used in the receiving device. The chip system may include a chip, or the chip system may include a chip and another discrete device.

It may be understood that, to implement the foregoing functions, the communication apparatus or the sensing apparatus includes corresponding hardware structures and/or software modules for performing the functions. A person skilled in the art should easily be aware that, in combination with units and algorithm steps of the examples described in embodiments disclosed in this specification, this application may be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the communication apparatus or the sensing apparatus may be divided into functional modules based on the foregoing method embodiments. For example, functional modules may be obtained through division based on corresponding functions, or two or more functions may be integrated into one processing module. The integrated module may be implemented in a form of hardware, or may be implemented in a form of a software functional module. It should be noted that, in embodiments of this application, module division is an example, and is merely a logical function division. In an actual implementation, another division manner may be used.

Apparatus FIG. 11 is a diagram of a structure of a communication apparatus or sensing apparatus 110. The apparatus 110 includes a processing module 1101 and a transceiver module 1102. The apparatus 110 may be configured to implement a function of the foregoing receiving device.

In some embodiments, the communication apparatus 110 may further include a storage module (not shown in FIG. 11), configured to store program instructions and data.

In some embodiments, the transceiver module 1102 may also be referred to as a transceiver unit, and is configured to implement a sending function and/or a receiving function. The transceiver module 1102 may include a transceiver circuit, a transceiver machine, a transceiver, or a communication interface.

In some embodiments, the transceiver module 1102 may include a receiving module and a sending module, respectively configured to perform receiving steps and sending steps performed by the receiving device in the foregoing method embodiments, and/or configured to support other processes of the technologies described in this specification. The processing module 1101 may be configured to perform processing (for example, determining) steps performed by the receiving device in the foregoing method embodiments, and/or configured to support other processes of the technologies described in this specification.

The transceiver module 1102 is configured to receive a first signal, where the first signal includes a target signal, the target signal occupies one subcarrier in every $M$ consecutive subcarriers, and $M$ is a positive integer greater than 1. The processing module 1101 is configured to perform down-conversion on the first signal to obtain a second signal. The processing module 1101 is further configured to determine a third signal based on the second signal, where the third signal includes superposition of $K$ delayed signals of the second signal, and delay time associated with a $k^{th}$ delayed signal in the

$K$ delayed signals is $\frac{(k-1)T}{K} + \delta$, where $T$ is a time length of the first signal, $k$ = 1,2,..., or $K$, $\delta$ is greater than or equal to 0, and $K$ is a positive integer greater than or equal to $M$. The processing module 1101 is further configured to sample the third signal to determine the target signal.

Optionally, that the processing module 1101 is further configured to determine the third signal based on the second signal includes: The processing module 1101 is further configured to delay the second signal $K$ times to obtain the $K$ delayed signals of the second signal, where the delay time associated with the $k$th delayed signal is $\frac{(k-1)T}{K} + \delta$; and the processing module 1101 is further configured to superpose the $K$ delayed signals to obtain the third signal.

Optionally, that the processing module 1101 is further configured to determine the third signal based on the second signal includes: The processing module 1101 is further configured to determine the third signal by using an $X$-stage circuit, where in the $X$-stage circuit, an output signal of an $i$th-stage circuit is a signal obtained by superposing an input signal of the $i$th-stage circuit and a signal obtained by delaying the input signal of the $i$th-stage circuit, where $i$ = 1, 2,..., or $X$, and $X$ is a positive integer greater than 1. When $i$ = 1, the input signal of the $i$th-stage circuit is a signal obtained by delaying the second signal by $\delta$, or when $i$ > 1, the input signal of the $i$th-stage circuit is an output signal of an $(i - 1)$th stage circuit, the third signal is an output signal of an $X$th-stage circuit, and the output signal of the $X$th-stage circuit includes superposition of the $K$ delayed signals of the second signal.

Optionally, when $K = M$, that the processing module 1101 is further configured to sample the third signal includes: The processing module 1101 is further configured to sample the third signal within a time range of $\left[\frac{M-1}{M}T + \delta, T + \delta\right]$, where a reference point of the time range is start time of the first signal.

Optionally, when $K$ = M, that the processing module 1101 is further configured to sample the third signal includes: The processing module 1101 is further configured to delay the third signal for $A$ times to obtain $A$ delayed signals of the third signal, where $A$ is a positive integer, delay time associated with an $a$th delayed signal is $\frac{(a-1)T}{M} + \delta_a$, $\delta_a$ is greater than or equal to 0, and $a$ = 1, 2,..., or $A$; and the processing module 1101 is further configured to sample the $a$th delayed signal of the third signal within a time range of $\left[\frac{M+a-2}{M}T + \delta + \sum_{j=1}^{a}\delta_j, \frac{M+a-1}{M}T + \delta + \sum_{j=1}^{a}\delta_j\right]$, where a reference point of the time range is start time of the first signal.

Optionally, $K = M - 1 + C$, and when $C$ is a positive integer, that the processing module 1101 is further configured to sample the third signal includes: The processing module 1101 is further configured to perform $C$ segments of sampling on the third signal. A $c$th segment of sampling corresponds to a signal of the third signal within a time range $c$, $c$ = 1, 2,..., or $C$, and the time range c is $\left[\frac{M+c-2}{M}T + \delta, \frac{M+c-1}{M}T + \delta\right]$. A reference point of the time range $c$ is start time of the first signal.

Optionally, that the processing module 1101 is further configured to sample the third signal to determine the target signal includes: The processing module 1101 is configured to sample the third signal to obtain a first time domain sequence, and is further configured to perform $N/M$-point discrete Fourier transform DFT on the first time domain sequence to obtain a frequency domain signal corresponding to the target signal, where $N$ is greater than or equal to a quantity of subcarriers included in a bandwidth of the first signal, and $N$ is a positive integer.

In a possible implementation, the functions/actions implemented by the processing module 1101 may alternatively be implemented by the transceiver module 1102.

All related content of the steps in the foregoing method embodiments may be cited in function descriptions of the corresponding functional modules. Details are not described herein again.

In this application, the communication apparatus or sensing apparatus 110 may be presented in a form of functional modules obtained through division in an integrated manner. The "module" herein may be an application-specific integrated circuit (application-specific integrated circuit, ASIC), a circuit, a processor that executes one or more software or firmware programs, a memory, an integrated logic circuit, and/or another component that can provide the foregoing functions.

In some embodiments, when the communication apparatus or sensing apparatus 110 in FIG. 11 is a chip or a chip system, a function/an implementation process of the transceiver module 1102 may be implemented through an input/output interface (or a communication interface) of the chip or the chip system, and a function/an implementation process of the processing module 1101 may be implemented by a processor (or a processing circuit) of the chip or the chip system.

Because the communication apparatus or sensing apparatus 110 provided in this embodiment may perform the foregoing methods, for a technical effect that can be achieved by the communication apparatus or sensing apparatus 110, refer to the foregoing method embodiments. Details are not described herein again.

Apparatus FIG. 12 is a diagram of a structure of another communication apparatus or sensing apparatus 120. The apparatus 120 may be configured to implement a function of the foregoing receiving device. The apparatus 120 includes a first circuit 1201.

Optionally, the apparatus 120 may further include at least one of the following: an antenna 1202, a frequency mixer 1203, an analog-to-digital converter 1204, a DFT module 1205, and a second circuit (not shown in FIG. 12).

The first circuit is configured to determine a third signal based on a second signal, where the second signal is a signal obtained by performing down-conversion on a first signal. The first signal includes a target signal, the target signal occupies one subcarrier in every $M$ consecutive subcarriers, and $M$ is a positive integer greater than 1. The third signal is an input signal of the analog-to-digital converter. The third signal includes superposition of $K$ delayed signals of the second signal, and delay time associated with a $k^{th}$ delayed signal in the $K$ delayed signals is $\frac{(k-1)T}{K} + \delta$, where $T$ is a time length of the first signal, $k = 1, 2, ..., or K$, $\delta$ is greater than or equal to 0, and $K$ is a positive integer greater than or equal to $M$.

Optionally, the antenna 1202 is configured to receive the first signal. The first signal includes the target signal, and the target signal occupies one subcarrier in every $M$ consecutive subcarriers.

Optionally, the frequency mixer 1203 is configured to perform down-conversion on the first signal to obtain the second signal.

Optionally, the analog-to-digital conversion module 1204 is configured to sample the third signal to obtain a first time domain sequence. The DFT module 1205 is configured to determine the target signal based on the first time domain sequence.

In a possible implementation, the first circuit includes $K$ delayers and one adder. A $k^{th}$ delayer in the $K$ delayers is configured to delay the second signal by $\frac{(k-1)T}{K} + \delta$ to obtain the $k^{th}$ delayed signal of the second signal. The adder is configured to superpose the $K$ delayed signals of the second signal to obtain the third signal. For example, the adder is a $K$-input adder.

In a possible implementation, the first circuit includes $K - 1$ delayers and one adder. A $k^{th}$ $(k = 1, 2, ... , or K - 1)$ delayer in the $K - 1$ delayers is configured to delay the second signal by $\frac{kT}{K} + \delta$ to obtain the $k^{th}$ delayed signal of the second signal. The adder is configured to superpose the second signal and $K - 1$ delayed signals of the second signal to obtain the third signal. For example, the adder is a $K$-input adder.

In another possible implementation, the first circuit includes an $X$-stage circuit, and in the $X$-stage circuit, an output signal of an $i^{th}$-stage circuit is a signal obtained by superposing an input signal of the $i^{th}$-stage circuit and a signal obtained by delaying the input signal of the $i^{th}$-stage circuit, where $i = 1, 2, ... , or X$, and $X$ is a positive integer greater than 1. When $i = 1$, the input signal of the $i^{th}$-stage circuit is a signal obtained by delaying the second signal by $\delta$, or when $i > 1$, the input signal of the $i^{th}$-stage circuit is an output signal of an $(i - 1)^{th}$ stage circuit, the third signal is an output signal of an $X^{th}$-stage circuit, and the output signal of the $X^{th}$-stage circuit includes superposition of the $K$ delayed signals of the second signal.

In a possible example, when $K = 2^X$, the $i^{th}$-stage circuit includes one delayer and one adder. The delayer is configured to delay the input signal of the $i^{th}$-stage circuit by $\frac{T}{2^i}$. The adder is configured to superpose the input signal of the $i^{th}$-stage circuit and an output signal of the delayer in the $i^{th}$-stage circuit. For example, the adder is a two-input adder.

In another possible example, when $K = \prod_{i=1}^{X} K_i$, the $i^{th}$-stage circuit includes $K_i - 1$ delayers and one adder. The $K_i - 1$ delayers are respectively configured to delay the input signal of the $i^{th}$-stage circuit by $\frac{T}{\prod_{j=1}^{i} K_j}$, $\frac{2T}{\prod_{j=1}^{i} K_j}$, ..., and $\frac{(K_i-1)T}{\prod_{j=1}^{i} K_j}$. The adder is configured to superpose the input signal of the $i^{th}$-stage circuit and output signals of the $K_i - 1$ delayers in the $i^{th}$-stage circuit. For example, the adder is a $K_i$-input adder.

Optionally, when $K = M$, the analog-to-digital converter 1204 is configured to sample the third signal within a time range of $\left[\frac{M-1}{M}T + \delta, T + \delta\right]$, where a reference point of the time range is start time of the first signal.

Optionally, when $K = M$, the second circuit is configured to delay the third signal $A$ times to obtain $A$ delayed signals of the third signal, where $A$ is a positive integer, delay time associated with an $a^{th}$ delayed signal is $\frac{(a-1)T}{M} + \delta_a$, $\delta_a$ is greater than or equal to 0, and $a = 1, 2,..., or A$. The analog-to-digital converter 1204 is configured to sample the $a^{th}$

delayed signal of the third signal within a time range of $\left[\frac{M+a-2}{M}T + \delta + \sum_{j=1}^{a}\delta_j, \frac{M+a-1}{M}T + \delta + \sum_{j=1}^{a}\delta_j\right]$, where a reference point of the time range is start time of the first signal.

For example, the second circuit includes $A$ delayers, and the $A$ delayers are separately configured to delay the third signal by $\frac{(a-1)T}{M} + \delta_a$. The communication apparatus or the sensing apparatus may further include a selector. The selector is configured to be connected to an $a^{\text{th}}$ delayer within the time range of $\left[\frac{M+a-2}{M}T + \delta + \sum_{j=1}^{a}\delta_j, \frac{M+a-1}{M}T + \delta + \sum_{j=1}^{a}\delta_j\right]$, so that the analog-to-digital converter 1204 samples the $a^{\text{th}}$ delayed signal of the third signal within the time range of $\left[\frac{M+a-2}{M}T + \delta + \sum_{j=1}^{a}\delta_j, \frac{M+a-1}{M}T + \delta + \sum_{j=1}^{a}\delta_j\right]$.

Optionally, when $K = M - 1 + B$, and $B$ is a positive integer, the analog-to-digital converter 1204 is configured to perform $C$ segments of sampling on the third signal. A $c^{\text{th}}$ segment of sampling corresponds to a signal of the third signal within a time range $c$, $c$ = 1, 2,..., or $C$, and the time range c is

$$\left[\frac{M+c-2}{M}T + \delta, \frac{M+c-1}{M}T + \delta\right].$$

A reference point of the time range c is start time of the first signal.

Optionally, the DFT module 1205 is specifically configured to perform $N/M$-point discrete Fourier transform DFT on the first time domain sequence to obtain a frequency domain signal corresponding to the target signal, where $N$ is greater than or equal to a quantity of subcarriers included in a bandwidth of the first signal, and $N$ is a positive integer.

All related content of the steps in the foregoing method embodiments may be cited in function descriptions of the corresponding circuits, components, or functional modules. Details are not described herein again.

In a possible product form, the receiving device in embodiments of this application may be further implemented by using one or more field programmable gate arrays (field programmable gate array, FPGA), a programmable logic device (programmable logic device, PLD), a controller, a state machine, gate logic, a discrete hardware component, any other suitable circuit, or any combination of circuits that can perform various functions described throughout this application.

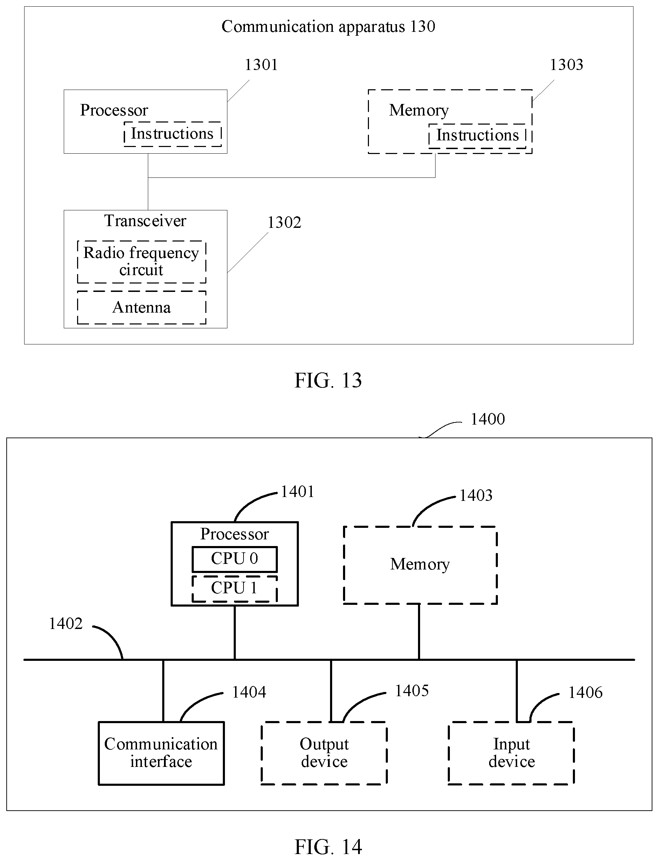

In another possible product form, the receiving device in embodiments of this application may be implemented by a general bus architecture. For ease of description, FIG. 13 is a diagram of a structure of a communication apparatus or sensing apparatus 130 according to an embodiment of this application. The apparatus 130 includes a processor 1301 and a transceiver 1302. The apparatus 130 may be a receiving device, or a chip or chip system in the receiving device. FIG. 13 shows only main components of the apparatus 130. In addition to the processor 1301 and the transceiver 1302, the apparatus may further include a memory 1303 and an input/output apparatus (not shown in the figure).

Optionally, the processor 1301 is mainly configured to process a communication protocol and communication data, control the entire communication apparatus or sensing apparatus, execute a software program, and process data of the software program. The memory 1303 is mainly configured to store a software program and data. The transceiver 1302 may include a radio frequency circuit and an antenna. The radio frequency circuit is mainly configured to perform conversion between a baseband signal and a radio frequency signal, and process the radio frequency signal. The antenna is mainly configured to receive and send radio frequency signals in a form of an electromagnetic wave. The input/output apparatus, for example, a touchscreen, a display, or a keyboard, is mainly configured to receive data input by a user and output data to the user.

Optionally, the processor 1301, the transceiver 1302, and the memory 1303 may be connected through a communication bus.

After the communication apparatus or sensing apparatus is powered on, the processor 1301 may read the software program in the memory 1303, interpret and execute instructions of the software program, and process data of the software program. When data needs to be sent wirelessly, the processor 1301 performs baseband processing on the to-be-sent data, and then outputs a baseband signal to the radio frequency circuit. The radio frequency circuit performs radio frequency processing on the baseband signal, and then sends the radio frequency signal in an electromagnetic wave form through the antenna. When data is sent to the communication apparatus or sensing apparatus, the radio frequency circuit receives a radio frequency signal through the antenna, converts the radio frequency signal into a baseband signal, and outputs the baseband signal to the processor 1301. The processor 1301 converts the baseband signal into data, and processes the data.

In another implementation, the radio frequency circuit and the antenna may be disposed independently of the processor that performs baseband processing. For example, in a distributed scenario, the radio frequency circuit and the antenna may be remotely disposed independently of the communication apparatus or sensing apparatus.

In some embodiments, in terms of hardware implementation, a person skilled in the art may figure out that the apparatus 110 may be in a form of the apparatus 130 shown in FIG. 13.

In an example, the functions or implementation processes of the processing module 1101 in FIG. 11 may be implemented by the processor 1301 in the apparatus 130 shown in FIG. 13 by invoking computer-executable instructions stored in the memory 1303. The functions or implementation processes of the transceiver module 1102 in FIG. 11 may be implemented by the transceiver 1302 in the apparatus 130 shown in FIG. 13.

In another possible product form, the receiving device in this application may use a composition structure shown in FIG. 14, or include components shown in FIG. 14. FIG. 14 is a composition diagram of a communication apparatus or sensing apparatus 1400 according to this application. The apparatus 1400 may be a receiving device or a chip or system on chip in the receiving device.

As shown in FIG. 14, the apparatus 1400 includes at least one processor 1401 and at least one communication interface (in FIG. 14, only an example in which one communication interface 1404 and one processor 1401 are included is used for description). Optionally, the apparatus 1400 may further include a communication bus 1402 and a memory 1403.

The processor 1401 may be a general-purpose central processing unit (central processing unit, CPU), a general-purpose processor, a network processor (network processor, NP), a digital signal processor (digital signal processor, DSP), a microprocessor, a microcontroller, a programmable logic device (programmable logic device, PLD), or any combination thereof. Alternatively, the processor 1401 may be another apparatus having a processing function, for example, a circuit, a device, or a software module. This is not limited.

The communication bus 1402 is configured to connect different components of the communication apparatus or sensing apparatus 1400, so that the different components can communicate with each other. The communication bus 1402 may be a peripheral component interconnect (peripheral component interconnect, PCI) bus, an extended industry standard architecture (extended industry standard architecture, EISA) bus, or the like. The bus may include an address bus, a data bus, a control bus, and the like. For ease of representation, only one bold line is used in FIG. 14 for representation, but this does not mean that there is only one bus or only one type of bus.

The communication interface 1404 is configured to communicate with another device or communication network. For example, the communication interface 1404 may be a module, a circuit, a transceiver, or any apparatus that can implement communication. Optionally, the communication interface 1404 may alternatively be an input/output interface located in the processor 1401, to implement signal input and signal output of the processor.

The memory 1403 may be an apparatus having a storage function, and is configured to store instructions and/or data. The instructions may be computer programs.

For example, the memory 1403 may be a read-only memory (read-only memory, ROM) or another type of static storage device that can store static information and/or instructions, may be a random access memory (random access memory, RAM) or another type of dynamic storage device that can store information and/or instructions, or may be an electrically erasable programmable read-only memory (electrically erasable programmable read-only memory, EEPROM), a compact disc read-only memory (compact disc read-only memory, CD-ROM) or another compact disc storage, an optical disc storage (including a compact disc, a laser disc, an optical disc, a digital versatile disc, a Blu-ray disc, and the like), or a magnetic disk storage medium or another magnetic storage device. This is not limited.

It should be noted that the memory 1403 may be independent of the processor 1401, or may be integrated with the processor 1401. The memory 1403 may be located in the communication apparatus or sensing apparatus 1400, or may be located outside the communication apparatus or sensing apparatus 1400. This is not limited. The processor 1401 is configured to execute the instructions stored in the memory 1403, to implement the methods provided in the following embodiments of this application.

In an optional implementation, the communication apparatus or sensing apparatus 1400 may further include an output device 1405 and an input device 1406. The output device 1405 communicates with the processor 1401, and may display information in a plurality of manners. For example, the output device 1405 may be a liquid crystal display (liquid crystal display, LCD), a light emitting diode (light emitting diode, LED) display device, a cathode ray tube (cathode ray tube, CRT) display device, or a projector (projector). The input device 1406 communicates with the processor 1401, and may receive an input of a user in a plurality of manners. For example, the input device 1406 may be a mouse, a keyboard, a touchscreen device, or a sensor device.

In some embodiments, in terms of hardware implementation, a person skilled in the art may figure out that the apparatus 110 shown in FIG. 11 may be in a form of the apparatus 1400 shown in FIG. 14.

In an example, the functions or implementation processes of the processing module 1101 in FIG. 11 may be implemented by the processor 1401 in the apparatus 1400 shown in FIG. 14 by invoking computer-executable instructions stored in the memory 1403. The functions or implementation processes of the transceiver module 1102 in FIG. 11 may be implemented by the communication interface 1404 in the apparatus 1400 shown in FIG. 14.

It should be noted that the structure shown in FIG. 14 does not constitute a specific limitation on the receiving device. For example, in some other embodiments of this application, the receiving device may include more or fewer components than those shown in the figure, combine some of the components, split some of the components, or have different layouts of the components. The components shown in the figure may be implemented by hardware, software, or a combination of software and hardware.

In some embodiments, an embodiment of this application further provides a communication apparatus or sensing apparatus. The apparatus includes a processor, configured to implement the method in any one of the foregoing method embodiments.

In a possible implementation, the communication apparatus or sensing apparatus further includes a memory. The memory is configured to store a necessary computer program and data. The computer program may include instructions. The processor may invoke instructions in the computer program stored in the memory, to instruct the communication apparatus or sensing apparatus to perform the method in any one of the foregoing method embodiments. Certainly, the memory may not be in the communication apparatus or sensing apparatus.

In another possible implementation, the communication apparatus or sensing apparatus further includes an interface circuit. The interface circuit is a code/data read/write interface circuit, and the interface circuit is configured to receive computer-executable instructions (where the computer-executable instructions are stored in the memory, and may be directly read from the memory, or may be read via another component) and send the computer-executable instructions to the processor.

In still another possible implementation, the communication apparatus or sensing apparatus further includes a communication interface, and the communication interface is configured to communicate with a module outside the communication apparatus or sensing apparatus.

It may be understood that the communication apparatus or sensing apparatus may be a chip or a chip system. When the communication apparatus or sensing apparatus is a chip system, the communication apparatus or sensing apparatus may include a chip, or may include a chip and another discrete device. This is not specifically limited in embodiments of this application.

This application further provides a computer-readable storage medium. The computer-readable storage medium stores a computer program or instructions. When the computer program or the instructions are executed by a computer, functions in any one of the foregoing method embodiments are implemented.

This application further provides a computer program product. When the computer program product is executed by a computer, functions in any one of the foregoing method embodiments are implemented.

A person of ordinary skill in the art may understand that, for the purpose of convenient and brief description, for a detailed working process of the foregoing system, apparatuses, and units, refer to a corresponding process in the foregoing method embodiments. Details are not described herein again.

It may be understood that the system, apparatus, and method described in this application may alternatively be implemented in another manner. For example, the described apparatus embodiments are merely examples. For example, division into the units is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or the units may be implemented in electronic, mechanical, or other forms.

The units described as separate parts may or may not be physically separate, and may be located in one position, or may be distributed on a plurality of network units. Parts displayed as units may be or may not be physical units. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit.

All or some of the foregoing embodiments may be implemented by using software, hardware, firmware, or any combination thereof. When a software program is used to implement embodiments, embodiments may be implemented completely or partially in a form of a computer program product. The computer program product includes one or more computer instructions. When the computer program instructions are loaded and executed on the computer, the procedure or functions according to embodiments of this application are all or partially generated. The computer may be a general-purpose computer, a dedicated computer, a computer network, or other programmable apparatuses. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk drive, or a magnetic tape), an optical medium (for example, a DVD), a semiconductor medium (for example, a solid-state drive (solid-state drive, SSD)), or the like. In embodiments of this application, the computer may include the foregoing apparatuses.

Although this application is described with reference to embodiments, in a process of implementing this application that claims protection, a person skilled in the art may understand and implement another variation of the disclosed embodiments by viewing the accompanying drawings, disclosed content, and appended claims. In the claims, "comprising" (comprising) does not exclude another component or another step, and "a" or "one" does not exclude a case of multiple. A single processor or another unit may implement several functions enumerated in the claims. Some measures are recorded in dependent claims that are different from each other, but this does not mean that these measures cannot be combined to produce a better effect.

Although this application is described with reference to specific features and embodiments thereof, it is clear that various modifications and combinations may be made to them without departing from the spirit and scope of this application. Correspondingly, the specification and accompanying drawings are merely example descriptions of this application defined by the appended claims, and are considered as any of or all modifications, variations, combinations or equivalents that cover the scope of this application. It is clearly that a person skilled in the art can make various modifications and variations to this application without departing from the spirit and scope of this application. This application is intended to cover these modifications and variations of this application provided that they fall within the scope of protection defined by the following claims and their equivalent technologies.

**Claims**

1. A signal receiving method, wherein the method comprises:

 receiving a first signal, wherein the first signal comprises a target signal, the target signal occupies one subcarrier in every $M$ consecutive subcarriers, and $M$ is a positive integer greater than 1;
 performing down-conversion on the first signal to obtain a second signal;
 determining a third signal based on the second signal, wherein the third signal comprises superposition of $K$ delayed signals of the second signal, and delay time associated with a $k^{th}$ delayed signal in the $K$ delayed signals is $\frac{(k-1)T}{K} + \delta$ , wherein $T$ is a time length of the first signal, $k = 1, 2, \ldots, or\, K$, $\delta$ is greater than or equal to 0, and $K$ is a positive integer greater than or equal to $M$; and
 sampling the third signal to determine the target signal.

2. The method according to claim 1, wherein a frequency of the down-conversion is related to a carrier frequency of the first signal and/or a position of the target signal.

3. The method according to claim 1 or 2, wherein determining the third signal based on the second signal comprises:

 delaying the second signal $K$ times to obtain the $K$ delayed signals of the second signal, wherein the delay time associated with the $k^{th}$ delayed signal is $\frac{(k-1)T}{K} + \delta$ ; and
 superposing the $K$ delayed signals to obtain the third signal.

4. The method according to claim 1 or 2, wherein determining the third signal based on the second signal comprises: determining the third signal by using an $X$-stage circuit, wherein in the X-stage circuit,

 an output signal of an $i^{th}$-stage circuit is a signal obtained by superposing an input signal of the $i^{th}$-stage circuit and a signal obtained by delaying the input signal of the $i^{th}$-stage circuit, wherein $i = 1, 2, \ldots, or\, X$, and $X$ is a positive integer greater than 1; and
 when $i = 1$, the input signal of the $i^{th}$-stage circuit is a signal obtained by delaying the second signal by $\delta$, or when $i > 1$, the input signal of the $i^{th}$-stage circuit is an output signal of an $(i - 1)^{th}$-stage circuit, the third signal is an output signal of an $X^{th}$-stage circuit, and the output signal of the $X^{th}$-stage circuit comprises superposition of the $K$ delayed signals of the second signal.

5. The method according to claim 4, wherein $K = 2^X$, and
 the output signal of the $i^{th}$-stage circuit is a signal obtained by superposing the input signal of the $i^{th}$-stage circuit and a signal obtained by delaying the input signal of the $i^{th}$-stage circuit by $\frac{T}{2^i}$ .

6. The method according to claim 4, wherein $K = \prod_{i=1}^{X} K_i$ , and

the output signal of the $i^{\text{th}}$-stage circuit is a signal obtained by superposing the input signal of the $i^{\text{th}}$-stage circuit and signals obtained by respectively delaying the input signal of the $i^{\text{th}}$-stage circuit by $\frac{T}{\prod_{j=1}^{i} K_j}$, $\frac{2T}{\prod_{j=1}^{i} K_j}$ , . .., and

$\frac{(K_i-1)T}{\prod_{j=1}^{i} K_j}$ , wherein $\Pi$ represents cumulative multiplication, and $K_i$ is a positive integer.

7. The method according to any one of claims 1 to 6, wherein $K = M$, and sampling the third signal comprises:

sampling the third signal within a time range of $\left[\frac{M-1}{M}T + \delta, T + \delta\right]$, wherein a reference point of the time range is start time of the first signal.

8. The method according to any one of claims 1 to 6, wherein $K = M$, and sampling the third signal comprises:

delaying the third signal $A$ times to obtain $A$ delayed signals of the third signal, wherein $A$ is a positive integer, delay time associated with an $a^{\text{th}}$ delayed signal is $\frac{(a-1)T}{M} + \delta_a$ , $\delta_a$ is greater than or equal to 0, and $a = 1, 2,..., or A$;
and
sampling the $a^{\text{th}}$ delayed signal of the third signal within a time range of $\left[\frac{M+a-2}{M}T + \delta + \sum_{j=1}^{a} \delta_j, \frac{M+a-1}{M}T + \delta + \sum_{j=1}^{a} \delta_j\right]$ , wherein a reference point of the time range is start time of the first signal.

9. The method according to claim 8, wherein a sampling frequency used for sampling the $a^{\text{th}}$ delayed signal of the third signal is greater than or equal to $N\Delta f_C/A$, wherein $N$ is greater than or equal to a quantity of subcarriers comprised in a bandwidth of the first signal, $N$ is a positive integer, and $\Delta f_C$ is a bandwidth of the subcarrier.

10. The method according to claim 8 or 9, wherein sampling positions of any two delayed signals in the $A$ delayed signals of the third signal are different.

11. The method according to any one of claims 1 to 6, wherein $K = M - 1 + C$, and $C$ is a positive integer.

12. The method according to claim 11, wherein sampling the third signal comprises:

performing $C$ segments of sampling on the third signal, wherein
a $c^{\text{th}}$ segment of sampling corresponds to a signal of the third signal within a time range $c$, $c = 1, 2, ... , or C,$ and the time range $c$ is

$$\left[\frac{M+c-2}{M}T + \delta, \frac{M+c-1}{M}T + \delta\right];$$

and
a reference point of the time range $c$ is start time of the first signal.

13. The method according to claim 12, wherein a sampling frequency used for performing $C$ segments of sampling on the third signal is greater than or equal to $N\Delta f_C/C$, wherein $N$ is greater than or equal to a quantity of subcarriers comprised in a bandwidth of the first signal, $N$ is a positive integer, and $\Delta f_C$ is a bandwidth of the subcarrier.

14. The method according to claim 12 or 13, wherein sampling positions in any two segments of sampling in the $C$ segments of sampling of the third signal are different.

15. The method according to any one of claims 1 to 14, wherein sampling the third signal to determine the target signal comprises:
sampling the third signal to obtain a first time domain sequence, and performing $N/M$-point discrete Fourier transform DFT on the first time domain sequence to obtain a frequency domain signal corresponding to the target signal, wherein $N$ is greater than or equal to the quantity of subcarriers comprised in the bandwidth of the first signal, and $N$ is a positive integer.

**16.** An apparatus, wherein the apparatus comprises a first circuit, wherein
the first circuit is configured to determine a third signal based on a second signal, wherein the third signal comprises superposition of $K$ delayed signals of the second signal, and delay time associated with a $k$th delayed signal in the $K$ delayed signals is $\frac{(k-1)T}{K} + \delta$; the second signal is a signal obtained by performing down-conversion on a first signal, the first signal comprises a target signal, the target signal occupies one subcarrier in every $M$ consecutive subcarriers, $M$ is a positive integer greater than 1, $T$ is a time length of the first signal, $k = 1, 2, ..., or K$, $\delta$ is greater than or equal to 0, and $K$ is a positive integer greater than or equal to $M$; and the third signal is an input signal of an analog-to-digital converter.

**17.** The apparatus according to claim 16, wherein the first circuit comprises $K$ delayers and one adder, wherein

a $k$th delayer in the $K$ delayers is configured to delay the second signal by $\frac{(k-1)T}{K} + \delta$ to obtain the $k$th delayed signal of the second signal; and
the adder is configured to superpose the $K$ delayed signals of the second signal to obtain the third signal.

**18.** The apparatus according to claim 16, wherein the first circuit comprises an X-stage circuit, and in the $X$-stage circuit,

an output signal of an $i$th-stage circuit is a signal obtained by superposing an input signal of the $i$th-stage circuit and a signal obtained by delaying the input signal of the $i$th-stage circuit, wherein $i = 1, 2, ... , or X$, and $X$ is a positive integer greater than 1; and
when $i = 1$, the input signal of the $i$th-stage circuit is a signal obtained by delaying the second signal by $\delta$, or when $i > 1$, the input signal of the $i$th-stage circuit is an output signal of an $(i-1)$th-stage circuit, the third signal is an output signal of an $X$th-stage circuit, and the output signal of the $X$th-stage circuit comprises superposition of the $K$ delayed signals of the second signal.

**19.** The apparatus according to claim 18, wherein $K = 2^X$, and the $i$th-stage circuit comprises one delayer and one adder, wherein

the delayer is configured to delay the input signal of the $i$th-stage circuit by $\frac{T}{2^i}$; and
the adder is configured to superpose the input signal of the $i$th-stage circuit and an output signal of the delayer in the $i$th-stage circuit.

**20.** The apparatus according to claim 18, wherein $K = \prod_{i=1}^{X} K_i$, and the $i$th-stage circuit comprises $K_i$ - 1 delayers and one adder, wherein

the $K_i$ - 1 delayers are respectively configured to delay the input signal of the $i$th-stage circuit by $\frac{T}{\prod_{j=1}^{i} K_j}$, $\frac{2T}{\prod_{j=1}^{i} K_j}$, ..., and $\frac{(K_i-1)T}{\prod_{j=1}^{i} K_j}$; and
the adder is configured to superpose the input signal of the $i$th-stage circuit and output signals of the $K_i$ - 1 delayers in the $i$th-stage circuit.

**21.** The apparatus according to any one of claims 16 to 20, wherein $K = M$, and the apparatus further comprises the analog-to-digital converter, wherein

the analog-to-digital converter is configured to sample the third signal within a time range of $\left[\frac{M-1}{M}T + \delta, T + \delta\right]$, wherein a reference point of the time range is start time of the first signal.

**22.** The apparatus according to any one of claims 16 to 20, wherein $K = M$, and the apparatus further comprises the analog-to-digital converter and a second circuit, wherein

the second circuit is configured to delay the third signal $A$ times to obtain $A$ delayed signals of the third signal, wherein $A$ is a positive integer, delay time associated with an $a^{\text{th}}$ delayed signal is $\frac{(a-1)T}{M} + \delta_a$, $\delta_a$ is greater than or equal to 0, and $a = 1, 2, ..., or\ A$; and

the analog-to-digital converter is configured to sample the $a^{\text{th}}$ delayed signal of the third signal within a time range of $\left[\frac{M+a-2}{M}T + \delta + \sum_{j=1}^{a}\delta_j, \frac{M+a-1}{M}T + \delta + \sum_{j=1}^{a}\delta_j\right]$, wherein a reference point of the time range is start time of the first signal.

23. The apparatus according to claim 22, wherein a sampling frequency used for sampling the $a^{\text{th}}$ delayed signal of the third signal is greater than or equal to $N\Delta f_C/A$, wherein $N$ is greater than or equal to a quantity of subcarriers comprised in a bandwidth of the first signal, $N$ is a positive integer, and $\Delta f_C$ is a bandwidth of the subcarrier.

24. The apparatus according to claim 22 or 23, wherein sampling positions of any two delayed signals in the $A$ delayed signals of the third signal are different.

25. The apparatus according to any one of claims 16 to 20, wherein $K = M - 1 + C$, and $C$ is a positive integer.

26. The apparatus according to claim 25, wherein the apparatus further comprises the analog-to-digital converter, wherein

the analog-to-digital converter is configured to perform $C$ segments of sampling on the third signal, wherein a $c^{\text{th}}$ segment of sampling corresponds to a signal of the third signal within a time range $c$, $c = 1, 2,..., or\ C,$ and the time range $c$ is

$$\left[\frac{M+c-2}{M}T + \delta, \frac{M+c-1}{M}T + \delta\right];$$

and

a reference point of the time range $c$ is start time of the first signal.

27. The apparatus according to any one of claims 16 to 26, wherein the apparatus further comprises a discrete Fourier transform module, wherein
the discrete Fourier transform module is configured to perform $N/M$-point discrete Fourier transform DFT on a first time domain sequence to obtain a frequency domain signal corresponding to the target signal, wherein $N$ is greater than or equal to the quantity of subcarriers comprised in the bandwidth of the first signal, $N$ is a positive integer, and the first time domain sequence is a sampling result corresponding to the third signal.

28. A chip, wherein the chip comprises a first circuit, wherein
the first circuit is configured to determine a third signal based on a second signal, wherein the third signal comprises superposition of $K$ delayed signals of the second signal, and delay time associated with a $k^{\text{th}}$ delayed signal in the $K$ delayed signals is $\frac{(k-1)T}{K} + \delta$; the second signal is a signal obtained by performing down-conversion on a first signal, the first signal comprises a target signal, the target signal occupies one subcarrier in every $M$ consecutive subcarriers, $M$ is a positive integer greater than 1, $T$ is a time length of the first signal, $k = 1, 2,..., or\ K$, $\delta$ is greater than or equal to 0, and $K$ is a positive integer greater than or equal to M; and the third signal is an input signal of an analog-to-digital converter.

29. The chip according to claim 28, wherein the chip further comprises the analog-to-digital converter, wherein
the analog-to-digital converter is configured to sample the third signal.

30. The chip according to claim 28 or 29, wherein the chip further comprises a discrete Fourier transform module, wherein
the discrete Fourier transform module is configured to perform $N/M$-point discrete Fourier transform DFT on a first time domain sequence to obtain a frequency domain signal corresponding to the target signal, wherein the first time domain sequence is a sampling result corresponding to the third signal, $N$ is greater than or equal to a quantity of subcarriers comprised in a bandwidth of the first signal, and $N$ is a positive integer.

31. An apparatus, wherein the apparatus comprises a processor, and the processor is configured to run a computer program or instructions, to cause the apparatus to perform the method according to any one of claims 1 to 15.

Subcarrier

CP

Symbol

FIG. 1

$B$

Time domain
signal

ADC → S->P → FFT → Extract a
signal →

FIG. 2

Sending
device ⟷ Receiving
device

FIG. 3

S401: A receiving device receives a first signal, where the first signal includes a target signal, and the target signal occupies one subcarrier in every $M$ consecutive subcarriers

S402: The receiving device performs down-conversion on the first signal to obtain a second signal

S403: The receiving device determines a third signal based on the second signal, where the third signal includes superposition of K delayed signals of the second signal, and delay time associated with a $k^{th}$ delayed signal is $\dfrac{(k-1)T}{K} + \delta$

S404: The receiving device samples the third signal

S405: The receiving device determines the target signal

FIG. 4

11

10

9

8

7

6

5

4

3

2

1

0

FIG. 5

FIG. 6

FIG. 7

First signal · Frequency mixer · $x(t)$ · Single-frequency signal · Adder · Delayed by $\frac{T}{2}$ · Delayed by $\frac{T}{6}$ · Delayed by $\frac{2T}{6}$ · $\sum_{k=1}^{K} x\left(t - \frac{(k-1)T}{K}\right)$ · ADC · $\frac{M-1}{M}T$ · $T$ · $x\left(t - \frac{T}{K}\right)$ · $x\left(t - \frac{2T}{K}\right)$ · $x\left(t - \frac{(K-1)T}{K}\right)$

FIG. 8

$\sum_{k=1}^{K} x\left(t - \frac{(k-1)T}{K}\right)$ · $\frac{M-1}{M}T$ · $T$ · Delayed by $\frac{T}{M}+\delta_2$ · Delayed by $\frac{2T}{M}+\delta_3$ · Delayed by $\frac{(K-2)T}{M}+\delta_{A-1}$ · Delayed by $\frac{(K-1)T}{M}+\delta_A$ · Selector · ADC

FIG. 9

Sampling point    First time range

1 2 3 4 5 6 7 8 9 10

1    3    5    7    9         2    4    6    8    10

Second time range when
a=1

$\delta_2$

Second time range when
a=2

FIG. 10

Communication apparatus          110

Processing module                1101

Transceiver module               1102

FIG. 11

120

| Antenna 1202 | Frequency mixer 1203 | First circuit 1201 | Analog-to-digital converter 1204 | DFT module 1205 |

FIG. 12

Communication apparatus 130

1301                                              1303

Processor                                        Memory
Instructions                                     Instructions

Transceiver                    1302

Radio frequency
circuit

Antenna

FIG. 13

1400

1401                          1403

Processor                     Memory

CPU 0

CPU 1

1402

1404              1405              1406

Communication          Output           Input
interface              device           device

FIG. 14

## INTERNATIONAL SEARCH REPORT

| International application No. |
|---|
| **PCT/CN2024/113195** |

| | |
|---|---|
| **A. CLASSIFICATION OF SUBJECT MATTER** | |
| H04L 27/26(2006.01)i | |

According to International Patent Classification (IPC) or to both national classification and IPC

**B. FIELDS SEARCHED**

Minimum documentation searched (classification system followed by classification symbols)

IPC:H04L

Documentation searched other than minimum documentation to the extent that such documents are included in the fields searched

Electronic data base consulted during the international search (name of data base and, where practicable, search terms used)

3GPP, CJFD, CNTXT, ENTXTC, VEN: 采样, 目标信号, 下变频, 周期延拓, 子载波, 延迟, 叠加, 频率, 时间范围, 带宽, 离散傅里叶变换, 时域序列, sampling, target signal, down-conversion, period extension, sub-carriers, delay, superposition, frequency, time range, bandwidth, DFT, time domain sequence

**C. DOCUMENTS CONSIDERED TO BE RELEVANT**

| Category* | Citation of document, with indication, where appropriate, of the relevant passages | Relevant to claim No. |
|---|---|---|
| X | CN 110166398 A (HARBIN INSTITUTE OF TECHNOLOGY) 23 August 2019 (2019-08-23) description, paragraphs 37-66 | 1-31 |
| A | WO 2018024151 A1 (SHANGHAI LANGBO COMMUNICATION TECHNOLOGIES CO., LTD.) 08 February 2018 (2018-02-08) entire document | 1-31 |
| A | CN 107426123 A (BEIJING RINFON TECHNOLOGY CO., LTD.) 01 December 2017 (2017-12-01) entire document | 1-31 |
| A | CN 108345014 A (NO.20 RESEARCH INSTITUTE OF CETC) 31 July 2018 (2018-07-31) entire document | 1-31 |
| A | CN 104931942 A (XIDIAN UNIVERSITY) 23 September 2015 (2015-09-23) entire document | 1-31 |

| ☐ Further documents are listed in the continuation of Box C. | ☑ See patent family annex. |
|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **16 October 2024** | **23 October 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/113195**

| Patent document cited in search report | | | Publication date (day/month/year) | Patent family member(s) | | | Publication date (day/month/year) |
|---|---|---|---|---|---|---|---|
| CN | 110166398 | A | 23 August 2019 | None | | | |
| WO | 2018024151 | A1 | 08 February 2018 | CN | 107666701 | A | 06 February 2018 |
| | | | | US | 2019159137 | A1 | 23 May 2019 |
| CN | 107426123 | A | 01 December 2017 | None | | | |
| CN | 108345014 | A | 31 July 2018 | None | | | |
| CN | 104931942 | A | 23 September 2015 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311160179